(19) Europäisches Patentamt / European Patent Office / Office européen des brevets

(11) **EP 4 372 030 B1**

(12) **EUROPEAN PATENT SPECIFICATION**

(45) Date of publication and mention of the grant of the patent:
**25.03.2026 Bulletin 2026/13**

(21) Application number: **22842044.4**

(22) Date of filing: **08.07.2022**

(51) International Patent Classification (IPC):
*H01L 23/29* (2006.01)    *C08F 283/10* (2006.01)
*C09J 4/06* (2006.01)    *C08L 81/02* (2006.01)
*C08G 75/045* (2016.01)

(52) Cooperative Patent Classification (CPC):
(C-Sets available)
**C08G 75/045; C08F 283/10; C08L 81/02;**
**C09J 4/06; H10W 74/47**                    (Cont.)

(86) International application number:
**PCT/JP2022/027060**

(87) International publication number:
**WO 2023/286700 (19.01.2023 Gazette 2023/03)**

(54) **CURABLE RESIN COMPOSITION**

HÄRTBARE HARZZUSAMMENSETZUNG

COMPOSITION DE RÉSINE DURCISSABLE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **14.07.2021 JP 2021116459**

(43) Date of publication of application:
**22.05.2024 Bulletin 2024/21**

(73) Proprietor: **Namics Corporation**
**Niigata-shi, Niigata 950-3131 (JP)**

(72) Inventors:
• **OTSUBO Kodai**
**Niigata-shi, Niigata 950-3131 (JP)**
• **SUZUKI Fumiya**
**Niigata-shi, Niigata 950-3131 (JP)**
• **SAKATA Yoko**
**Niigata-shi, Niigata 950-3131 (JP)**

(74) Representative: **Hoffmann Eitle**
**Patent- und Rechtsanwälte PartmbB**
**Arabellastraße 30**
**81925 München (DE)**

(56) References cited:
WO-A1-2012/147712    WO-A1-2012/164869
WO-A1-2016/114268    WO-A1-2018/155013
JP-A- 2003 302 759    JP-A- 2013 043 902
JP-A- 2014 141 621    JP-A- 2017 101 112
JP-A- 2017 210 475    JP-A- 2021 075 698
JP-A- 2021 075 698    US-A1- 2017 158 922
US-A1- 2020 385 513

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 372 030 B1

(52) Cooperative Patent Classification (CPC): (Cont.)

C-Sets
**C08F 283/10, C08F 222/102, C08F 220/1811;**
**C08F 283/10, C08F 222/102, C08F 220/1811,**

**C08F 222/1065;**
**C08F 283/10, C08F 222/102, C08F 220/301;**
**C08F 283/10, C08F 222/102, C08F 220/302;**
**C08F 283/10, C08F 222/104, C08F 220/1811;**
**C09J 4/06, C08F 283/10**

**Description**

Field of the Invention

The present invention relates to curable resin compositions, adhesives containing the same, cured products obtained by curing the same, and semiconductor devices and sensor modules containing the cured products.

Background Art

Adhesives that are cured by a two-step process that includes curing by ultraviolet (UV) irradiation (UV curing) and subsequent curing by heating (thermal curing) (hereinafter referred to as "UV- and thermo-curable adhesives") are used in many fields (see, for example, Patent Document 1). UV- and thermo-curable adhesives are useful because they can be cured by heating, even when applied to positions where UV irradiation cannot be applied to the entire adhesive (see, for example, Patent Document 2). Some UV- and thermo-curable adhesives contain polyfunctional (meth)acrylate compounds and polyfunctional thiol compounds.

UV- and thermo-curable adhesives are often used in the manufacture of semiconductor devices, especially those requiring high-precision positioning in assembly, e.g., image sensor modules. In image sensor modules, the relative positional relationship between each component/part is extremely important. Therefore, the assembly of image sensor modules requires high-precision positioning of each component/part. When UV- and thermo-curable adhesives are used, the parts can be temporarily fixed with UV curing to prevent peeling and/or misalignment of the parts during heat curing. It also makes it possible, for example, to transport an intermediate assembly before heat curing, in which each component has been temporarily fixed by UV curing, to a location where heat curing is performed without changing the relative positional relationship between each component. Therefore, the use of UV- and thermo-curable adhesives in the manufacture of image sensor modules is extremely useful because it improves assembly efficiency. Patent Document 3 discloses an adhesive prepared from a curable composition comprising a polyfunctional (meth)acrylate compound, a monofunctional (meth)acrylate compound with a molecular weight of 400 or less, a polyfunctional thiol compound, a photo-radical initiator and a thermal curing accelerator. Patent Document 4 discloses a semiconductor device comprising an adhesive layer prepared from a curable composition comprising a polyfunctional (meth)acrylate compound, a monofunctional (meth)acrylate compound with a molecular weight of 400 or less, an epoxy resin, a photo-radical initiator and a thermal curing accelerator.

PRIOR ART REFERENCE

Patent Document

Patent Document 1: Japanese Unexamined Patent Publication No. 2014-077024
Patent Document 2: WO 2018/181421, Patent Document 3: Japanese Unexamined Patent Publication No. 2021-075698, Patent Document 4: US 2017/158922 A1.

Summary of the Invention

Problems to be Solved by the Invention

However, conventional UV- and thermo-curable adhesives have a problem when used in the intermediate assemblies described above, where peeling and/or misalignment of parts may occur, for example, when the parts are subjected to impact during transportation.

This peeling and/or misalignment occurs when the intermediate assembly is subjected to stress, especially peeling stress and/or shear stress, due to impacts received during transportation. Therefore, both shear strength and peel strength after curing treatment by UV irradiation (UV curing treatment) must be sufficiently high to prevent such peeling and/or misalignment. However, it has been difficult to achieve both shear strength and peel strength after UV curing when using conventional UV- and thermo-curable adhesives.

Depending on the structure of the adherend, there may be areas in the adherend that cannot be irradiated with UV light over the entirety of the applied UV- and thermo-curable adhesives during the UV curing process. In such cases, some of the applied UV- and thermo-curable adhesives remains unreacted at the completion of the UV curing process, and the area of the UV-cured product that contributes to adhesion (i.e., UV- and thermo-curable adhesive that has experienced only UV curing treatment) is only a portion of the area of the UV- and thermo-curable adhesive that is in contact with the adherend. Because of this, a UV- and thermo-curable adhesive that gives UV-cured products that exhibit sufficient adhesive strength, especially peel strength and shear strength, has been desired.

When the intermediate assembly is subjected to curing treatment by heating (thermal curing treatment), a final assembly is obtained in which each component is bonded by UV curing and thermal curing. When the intermediate assembly contains unreacted UV- and thermo-curable adhesive as described above, cured products in the final assembly include UV-thermally cured products (UV- and thermo-curable adhesives that have experienced both UV and thermal cure treatments) and thermally cured products (UV- and thermo-curable adhesives that have experienced only thermal cure treatments). To achieve strong adhesion of each component in the final assembly, not only the UV-thermally cured products but also the thermally cured products must exhibit high adhesion strength. Therefore, a UV- and thermo-curable adhesive that also gives a heat-cured product that exhibits high adhesive strength has been desired.

The object of the present invention is to provide a UV- and thermo-curable resin composition that exhibits sufficiently high adhesive strength when subjected to UV-curing treatment and heat-curing treatment, in order to solve the problems of the conventional technologies described above.

Means for Solving the Problems

The inventors have conducted intensive study in order to solve the above problems, and have arrived at the present invention.

In other words, the present invention encompasses, but is not limited to, the following embodiments.

[1] A curable resin composition comprising the following components (A) to (F):

(A) a polyfunctional (meth)acrylate compound,
(B) a monofunctional (meth)acrylate compound with a molecular weight of 400 or less,
(C) an epoxy resin,
(D) a polyfunctional thiol compound,
(E) a photo-radical initiator, and
(F) a thermal curing accelerator,

wherein [total number of (meth)acryloyl groups for the (B) monofunctional (meth)acrylate compound + total number of epoxy groups for the (C) epoxy resin] / [total number of thiol groups for the (D) polyfunctional thiol compound] is 0.1 to 0.5, [total number of (meth)acryloyl groups for the (B) monofunctional (meth)acrylate compound] / [total number of thiol groups for the (D) polyfunctional thiol compound] is 0.05 to 0.45, and [total number of epoxy groups for the (C) epoxy resin] / [total number of thiol groups for the (D) polyfunctional thiol compound] is 0.05 to 0.45.

[2] The curable resin composition as described in [1] above, wherein [total number of (meth)acryloyl groups for the (B) monofunctional (meth)acrylate compound + total number of epoxy groups for the (C) epoxy resin] / [total number of thiol groups for the (D) polyfunctional thiol compound] is 0.3 to 0.5.

[3] The curable resin composition as described in [1] or [2] above, wherein the (D) polyfunctional thiol compound has three or more thiol groups.

[4] The curable resin composition as described in any one of [1] to [3] above, wherein the (D) polyfunctional thiol compound contains a trifunctional thiol compound and/or a tetrafunctional thiol compound.

[5] The curable resin composition as described in any one of [1] to [4] above, wherein the (A) polyfunctional (meth)acrylate compound contains a bifunctional (meth)acrylate compound.

[6] An adhesive comprising the curable resin composition as described in any one of [1] to [5] above.

[7] A cured product obtainable by curing the curable resin composition as described in any one of [1] to [5] above or the adhesive as described in [6] above.

[8] A semiconductor device comprising the cured product as described in [7] above.

[9] A sensor module comprising the cured product as described in [7] above.

The curable resin composition of the present invention contains as essential components (A) a polyfunctional (meth)acrylate compound, (B) a monofunctional (meth)acrylate compound with a molecular weight of 400 or less, (C) an epoxy resin, (D) a polyfunctional thiol compound, (E) a photo-radical initiator, and (F) a thermal curing accelerator. These components are described below.

In the present description, following conventions in the field of synthetic resins, names that include the term "resin" that usually refer to polymers (especially synthetic polymers) may be used for components of pre-cured curable resin compositions, even though the component is not a polymer.

In present description, the names "(meth)acrylic acid", "(meth)acrylate", "(meth)acryl", and "(meth)acryloyl" may be used as generic terms for "acrylic acid" (or its derivative) and "methacrylic acid" (or its derivative). Each of these terms may be used as one independent term or as part of another term. For example, the term "(meth)acrylic acid" means "acrylic acid and/or methacrylic acid", and the term "(meth)acryloyloxy group" means "acryloyloxy and/or methacryloyloxy groups".

(A) Polyfunctional (meth)acrylate compound

The curable resin composition of the present invention contains a polyfunctional (meth)acrylate compound. The polyfunctional (meth)acrylate compounds used in the present invention are compounds containing a total of two or more (meth)acryloyl groups that react with thiol groups in the polyfunctional thiol compounds described below in the form of (meth)acryloyloxy groups. In other words, a polyfunctional (meth)acrylate compound is a compound having a structure in which one molecule of a compound having two or more hydroxyl groups is being esterified with a total of two or more molecules of a (meth)acrylic acid. The polyfunctional (meth)acrylate compound may have a hydroxyl group that is not esterified. However, silane coupling agents having one (meth)acrylate group are not included in polyfunctional (meth) acrylate compound. Preferably, the polyfunctional (meth)acrylate compound does not contain silicon atoms.

The polyfunctional (meth)acrylate compound may contain (meth)acryloyl groups that are not in the form of (meth) acryloyloxy groups, as long as the above structural requirements are met. For example, N,N'-methylenebisacrylamide is not a polyfunctional (meth)acrylate compound. The (A) polyfunctional (meth)acrylate compound is preferably one with a molecular weight of 100 to 10,000, more preferably one with a molecular weight of 200 to 5,000, even more preferably one with a molecular weight of 200 to 3,000, and especially preferably one with a molecular weight of 200 to 800.

Examples of the polyfunctional (meth)acrylate compound include, but are not limited to:

- di(meth)acrylate of bisphenol A;
- di(meth)acrylate of bisphenol F;
- polyfunctional (meth)acrylate with isocyanurate skeleton;
- di(meth)acrylate of dimethylol tricyclodecane;
- polyfunctional (meth)acrylate of trimethylolpropane or an oligomer thereof;
- polyfunctional (meth)acrylate of ditrimethylolpropane;
- polyfunctional (meth)acrylate of pentaerythritol or an oligomer thereof;
- polyfunctional (meth)acrylate of dipentaerythritol;
- di(meth)acrylate of trimethylolpropane modified with neopentylglycol;
- di(meth)acrylate of polyethylene glycol;
- di(meth)acrylate of polypropylene glycol;
- di(meth)acrylate of chain or cyclic alkanediols;
- di(meth)acrylate of neopentyl glycol;
- polyurethanes having two or more (meth)acryloyl groups per molecule;
- polyesters having two or more (meth)acryloyl groups per molecule; and
- polyfunctional (meth)acrylate of glycerin.

Among these, di(meth)acrylate of dimethylol tricyclodecane, (tri/tetra)(meth)acrylate of ditrimethylolpropane, hexa(meth) acrylate of dipentaerythritol, di(meth)acrylate of neopentyl glycol modified trimethylolpropane, and polyurethane with two (meth)acryloyl groups per molecule are preferred. Any one of them may be used alone, or two or more may be used in combination. In the present description, "polyfunctional (meth)acrylate" refers to a compound containing two or more (meth)acryloyloxy groups. For example, "polyfunctional (meth)acrylate of trimethylolpropane or an oligomer thereof" refers to an ester of one molecule of trimethylolpropane or an oligomer thereof with two or more molecules of (meth)acrylic acid.

In the present invention, it is preferred that the polufunctional (meth)acrylate compound includes a bifunctional (meth)acrylate compound. Bifunctional (meth)acrylate compounds are polyfunctional (meth)acrylate compounds having a total of two (meth)acryloyl groups. Similarly, for example, trifunctional and tetrafunctional (meth)acrylate compounds are polyfunctional (meth)acrylate compounds having three and four (meth)acryloyl groups, respectively.

In the present invention, silane coupling agents having multiple (meth)acrylate groups are not included in the polyfunctional (meth)acrylate compounds. Preferably, the polyfunctional (meth)acrylate compound does not contain a silicon atom.

(B) Monofunctional (meth)acrylate compound with a molecular weight of 400 or less

The curable resin composition of the present invention contains a monofunctional (meth)acrylate compound with a molecular weight of 400 or less. The monofunctional (meth)acrylate compound used in the present invention is a compound containing one (meth)acryloyl group in the form of a (meth)acryloyloxy group that reacts with the thiol group in the polyfunctional thiol compound described below. In other words, a monofunctional (meth)acrylate compound is a compound with a structure in which one molecule of a compound having one or more hydroxyl groups is being esterified with one molecule of (meth)acrylic acid. The monofunctional (meth)acrylate compound may have a hydroxyl group that is not being esterified. However, silane coupling agents with one (meth)acrylate group are not included in this monofunctional (meth)acrylate compound. Preferably, this monofunctional (meth)acrylate compound does not contain a silicon atom. Preferably, the (B) monofunctional (meth)acrylate compound has no reactive functional groups other than (meth)acrylate groups in the molecule.

The monofunctional (meth)acrylate compound used in the present invention has a molecular weight of 400 or less. The molecular weight of the monofunctional (meth)acrylate compound is preferably 380 or less, more preferably 360 or less, and even more preferably 340 or less. The use of monofunctional (meth)acrylate compounds with molecular weights in excess of 400 reduces peel strength and shear strength after UV curing. This is presumably because bulky residues derived from monofunctional (meth)acrylate compounds with molecular weights in excess of 400 gather together in the UV-cured curable resin composition (UV-cured product) to form a crystalline portion, and this portion adversely affects the properties of the UV-cured product.

Examples of the monofunctional (meth)acrylate compound include:

- esters of monovalent alcohols and (meth)acrylic acids such as ethyl (meth)acrylate, trifluoroethyl (meth)acrylate, diethylaminoethyl (meth)acrylate, dimethylaminoethyl (meth)acrylate, glycidyl (meth)acrylate, n-butyl (meth)acrylate, isobutyl (meth)acrylate, tert-butyl (meth)acrylate, isoamyl (meth)acrylate, cyclohexyl (meth)acrylate, 2-ethylhexyl (meth)acrylate, isodecyl (meth)acrylate, isobornyl (meth)acrylate, stearyl (meth)acrylate, lauryl (meth)acrylate, phenoxyethyl (meth)acrylate, benzyl (meth)acrylate, tetrahydrofurfuryl (meth)acrylate, ethoxydiethylene glycol (meth)acrylate, phenoxydiethylene glycol (meth)acrylate, phenoxypolyethylene glycol (meth)acrylate, butoxydiethylene glycol (meth)acrylate, methoxydipropylene glycol (meth)acrylate, methoxypolyethylene glycol (meth)acrylate, methoxytriethylene glycol (meth)acrylate, methoxypolyethylene glycol (meth)acrylate, 2-ethylhexyl diethylene glycol (meth)acrylate, 4-tert-butylcyclohexyl (meth)acrylate, and 3-phenoxybenzyl(meth)acrylate;
- mono(meth)acrylates of polyhydric alcohols or esters of monovalent alcohols and (meth)acrylic acids such as 2-hydroxyethyl(meth)acrylate, 2-hydroxypropyl(meth)acrylate, 2-hydroxybutyl(meth)acrylate, 2-hydroxy-3-phenoxypropyl(meth)acrylate, octyl acrylate, nonyl acrylate, isononyl acrylate, 3,3,5-trimethylcyclohexyl acrylate, cyclic trimethylolpropane formal acrylate, 1-naphthalene methyl(meth)acrylate, 1-ethylcyclohexyl (meth)acrylate, 1-methylcyclohexyl (meth)acrylate, 1-ethylcyclopentyl (meth)acrylate, 1-methylcyclopentyl(meth)acrylate, dicyclopentenyl(meth)acrylate, dicyclopentenyloxyethyl(meth)acrylate, dicyclopentanyl(meth)acrylate, nonylphenoxy polyethylene glycol(meth)acrylate, tetrahydrodicyclopentadienyl(meth)acrylate, 2-(o-phenylphenoxy)ethyl(meth)acrylate, isobornylcyclohexyl(meth)acrylate, (2-methyl-2-ethyl-1,3-dioxolan-4-yl)methyl(meth)acrylate, 1-adamantyl(meth)acrylate, 3-hydroxy-1-adamantyl(meth)acrylate, 2-methyl-2-adamantanyl(meth)acrylate, 2-ethyl-2-adamantanyl(meth)acrylate, 2-isopropyladamantan-2-yl(meth)acrylate, 3-hydroxy-1-adamantyl(meth)acrylate, (adamantan-1-yloxy)methyl(meth)acrylate, 2-isopropyl-2-adamantyl(meth)acrylate, 1-methyl-1-ethyl-1-adamantylmethanol(meth)acrylate, 1,1-diethyl-1-adamantylmethanol(meth)acrylate, 2-cyclohexylpropan-2-yl(meth)acrylate, 1-isopropylcyclohexyl(meth)acrylate, 1-methylcyclohexyl(meth)acrylate, 1-ethylcyclopentyl(meth)acrylate, 1-methylcyclohexyl(meth)acrylate, tetrahydropyranyl(meth)acrylate, tetrahydro-2-furanyl(meth)acrylate, 2-oxotetrahydrofuran-3-yl(meth)acrylate, (5-oxotetrahydrofuran-2-yl)methyl(meth)acrylate, (2-oxo-1,3-dioxolan-4-yl)methyl(meth)acrylate, 1-ethoxyethyl(meth)acrylate; and the like. Any one of them may be used alone, or two or more may be used in combination. The monofunctional (meth)acrylate compound preferably contains one having the molecular weight from 100 to 400, more preferably from 120 to 380, even more preferably from 140 to 360, and especially preferably from 160 to 340.

(C) Epoxy resin

The curable resin composition of the present invention contains an epoxy resin. The epoxy resins used in the present invention are compounds containing one or more epoxy groups that react with thiol groups in the polyfunctional thiol compounds. Normally, an epoxy group and a thiol group do not react with each other under UV irradiation, but they can react with each other under heating. Therefore, epoxy resins usually do not react with polyfunctional thiol compounds under UV irradiation, but if a heat curing accelerator (especially a basic component) is present in the system or on the adherend surface, they can react with polyfunctional thiol compounds only at their epoxy groups under heating.

Epoxy resins are broadly classified into monofunctional epoxy resins and polyfunctional epoxy resins. The epoxy resin may contain only one of these or both. From the viewpoint of thermal curability, the epoxy resin preferably contains a polyfunctional epoxy resin. The epoxy resin is particularly preferred to contain a bifunctional epoxy resin. In some aspects, the epoxy resin is preferably liquid at 25°C. In the present description, "liquid epoxy resin" refers to an epoxy resin whose physical state is liquid at 25°C.

Monofunctional epoxy resins are epoxy resins containing one epoxy group. Examples of monofunctional epoxy resins include, but are not limited to, n-butyl glycidyl ether, 2-ethylhexyl glycidyl ether, phenyl glycidyl ether, kresyl glycidyl ether, p-s-butylphenyl glycidyl ether, styrene oxide, $\alpha$-pinene oxide, 4-tert-butylphenyl glycidyl ether, neodecanoic acid glycidyl ester, 2-(4,4-dimethylpentan-2-yl)-5,7,7-trimethyloctanoic acid glycidyl ester, and the like. Any one of them may be used alone, or two or more may be used in combination.

Polyfunctional epoxy resins are epoxy resins containing two or more epoxy groups. Polyfunctional epoxy resins are broadly classified into aliphatic polyfunctional epoxy resins and aromatic polyfunctional epoxy resins. Aliphatic polyfunctional epoxy resins are polyfunctional epoxy resins with a structure that does not contain aromatic rings. Examples of aliphatic polyfunctional epoxy resins include, but are not limited to:

- diepoxy resins such as (poly)ethylene glycol diglycidyl ether, (poly)propylene glycol diglycidyl ether, butanediol diglycidyl ether, neopentyl glycol diglycidyl ether, 1,6-hexanediol diglycidyl ether, trimethylolpropane diglycidyl ether, polytetramethylene ether glycol diglycidyl ether, glycerol diglycidyl ether, neopentyl glycol diglycidyl ether, 1,2-epoxy-4-(2-methyloxiranyl)-1-methylcyclohexane, cyclohexane type diglycidyl ether, and dicyclopentadiene type diglycidyl ether;
- triepoxy resins such as trimethylolpropane triglycidyl ether, glycerin triglycidyl ether;
- alicyclic epoxy resins such as vinyl (3,4-cyclohexene) dioxide, 2-(3,4-epoxycyclohexyl)-5,1-spiro-(3,4-epoxycyclohexyl)-m-dioxane;
- glycidylamine type epoxy resins such as tetraglycidyl bis(aminomethyl)cyclohexane;
- hydantoin type epoxy resins such as 1,3-diglycidyl-5-methyl-5-ethylhydantoin; and
- epoxy resins with silicone skeleton such as 1,3-bis(3-glycidoxypropyl)-1,1,3,3-tetramethyldisiloxane.

Any one of them may be used alone, or two or more may be used in combination.

Aromatic polyfunctional epoxy resins are polyfunctional epoxy resins with structures containing aromatic rings. Many epoxy resins frequently used in the past, such as bisphenol A epoxy resins, are of this type. Examples of aromatic polyfunctional epoxy resins include, but are not limited to:

- bisphenol A epoxy resins;
- branched polyfunctional bisphenol A epoxy resins such as -p-glycidyloxyphenyl dimethyl tris-bisphenol A diglycidyl ether;
- bisphenol F epoxy resins;
- novolac epoxy resins;
- tetrabromobisphenol A epoxy resin;
- fluorene epoxy resin;
- biphenyl aralkyl epoxy resins;
- diepoxy resins such as 1,4-phenyldimethanol diglycidyl ether;
- biphenyl epoxy resins such as 3,3',5,5'-tetramethyl-4,4'-diglycidyloxybiphenyl;
- glycidylamine epoxy resins such as diglycidylaniline, diglycidyltoluidine, triglycidyl-p-aminophenol, and tetraglycidyl-m-xylylenediamine; and
- naphthalene ring-containing epoxy resins.

Any one of them may be used alone, or two or more may be used in combination.

The epoxy equivalent weight of the epoxy resin is preferably from 90 to 500 g/eq, more preferably from 100 to 450 g/eq, and even more preferably from 100 to 350 g/eq.

(D) Polyfunctional thiol compound

The curable resin composition of the present invention contains a polyfunctional thiol compound. The polyfunctional thiol compounds used in the present invention are compounds containing two or more thiol groups that react with (meth)acryloyl groups (or more precisely, double bonds therein) in the aforementioned polyfunctional (meth)acrylate compounds and monofunctional (meth)acrylate compounds, and with epoxy groups in epoxy resins. The polyfunctional thiol compound preferably has three or more thiol groups. It is more preferred that the polyfunctional thiol compound includes a trifunctional and/or tetrafunctional thiol compound. Trifunctional and tetrafunctional thiol compounds are thiol compounds with three and four thiol groups, respectively. The thiol equivalent weight of the polyfunctional thiol compound is preferably 90 to 150 g/eq, more preferably 90 to 140 g/eq, and even more preferably 90 to 130 g/eq.

Polyfunctional thiol compounds are broadly classified into thiol compounds with hydrolyzable substructures such as ester bonds in their molecules (i.e., hydrolyzable thiol compounds) and thiol compounds without such substructures (i.e., nonhydrolyzable thiol compounds).

Examples of the hydrolyzable polyfunctional thiol compound include trimethylolpropane tris(3-mercaptopropionate) (trade name: TMMP; available from SC Organic Chemical Co., Ltd.), tris[(3-mercaptopropionyloxy)-ethyl]-isocyanurate (trade name: TEMPIC; available from SC Organic Chemical Co., Ltd.), pentaerythritol tetrakis(3-mercaptopropionate) (trade name: PEMP; available from SC Organic Chemical Co., Ltd.), tetraethyleneglycol bis(3-mercaptopropionate) (trade name: EGMP-4; available from SC Organic Chemical Co., Ltd.), dipentaerythritol hexakis(3-mercaptopropionate) (trade name: DPMP; available from SC Organic Chemical Co., Ltd.), pentaerythritol tetrakis(3-mercaptobutyrate) (trade name: Karenz MT® PE1; available from Showa Denko K.K.), 1,3,5-tris(3-mercaptobutyryloxyethyl)-1,3,5-triazine-2,4,6(1H,3H,5H)-trione (trade name: Karenz MT® NR1; available from Showa Denko K.K.), and the like. Any one of them may be used alone, or two or more may be used in combination.

Examples of the non-hydrolyzable polyfunctional thiol compound include 1,3,4,6-tetrakis(2-mercaptoethyl) glycoluril (trade name: TS-G, available from Shikoku Chemicals Corporation), 1,3,4,6-tetrakis(3-mercaptopropyl)glycoluril (trade name: C3 TS-G, available from Shikoku Chemicals Corporation), 1,3,4,6-tetrakis(mercaptomethyl)glycoluril, 1,3,4,6-tetrakis(mercaptomethyl)-3a-methylglycoluril, 1,3,4,6-tetrakis(2-mercaptoethyl)-3a-methylglycoluril, 1,3,4,6-tetrakis(3-mercaptopropyl)-3a-methylglycoluril, 1,3,4,6-tetrakis(mercaptomethyl)-3a, 6a-dimethylglycoluril, 1,3,4,6-tetrakis(2-mercaptoethyl)-3a,6a-dimethylglycoluril, 1,3,4,6-tetrakis(3-mercaptopropyl)-3a,6a-dimethylglycoluril, 1,3,4,6-tetrakis(mercaptomethyl)-3a,6a-diphenylglycoluril, 1,3,4,6-tetrakis(2-mercaptoethyl)-3a,6a-diphenylglycoluril, 1,3,4,6-tetrakis(3-mercaptopropyl)-3a,6a-diphenylglycoluril, tris(3-mercaptopropyl)isocyanurate, 1,3,5-tris[3-(2-mercaptoethylsulfanyl)propyl isocyanurate, 1,3,5-tris[2-(3-mercaptopropoxy)ethyl]isocyanurate, pentaerythritol tripropanethiol (trade name: PEPT, available from SC Organic Chemical Co., Ltd.), pentaerythritol tetrapropanethiol, 1,2,3-tris(mercaptomethylthio)propane, 1,2,3-tris(2-mercaptoethylthio)propane, 1,2,3-tris(3-mercaptopropylthio)propane, 4-mercaptomethyl-1,8-dimercapto-3,6-dithiaoctane, 5,7-dimercaptomethyl-1,11-dimercapto-3,6,9-trithiaundecane, 4,7-dimercaptomethyl-1,11-dimercapto-3,6,9-trithiaundecane, 4,8-dimercaptomethyl-1,11-dimercapto-3,6,9-trithiaundecane, tetrakis(mercaptomethylthiomethyl)methane, tetrakis(2-mercaptoethylthiomethyl)methane, tetrakis(3-mercaptopropylthiomethyl)methane, 1,1,3,3-tetrakis(mercaptomethylthio)propane, 1,1,2,2-tetrakis(mercaptomethylthio)ethane, 1,1,5,5-tetrakis(mercaptomethylthio)-3-thiapentane, 1,1,6,6-tetrakis(mercaptomethylthio)-3,4-dithiahexane, 2,2-bis(mercaptomethylthio)ethanethiol, 3-mercaptomethylthio-1,7-dimercapto-2,6-dithiaheptane, 3,6-bis(mercaptomethylthio)-1,9-dimercapto-2,5,8-trithianonane, 3-mercaptomethylthio-1,6-dimercapto-2,5-dithiahexane, 1,1,9,9-tetrakis(mercaptomethylthio)-5-(3,3-bis(mercaptomethylthio)-1-thiapropyl) 3,7-dithianonane, tris(2,2-bis(mercaptomethylthio)ethyl) methane, tris(4,4-bis(mercaptomethylthio)-2-thiabutyl)methane, tetrakis(2,2-bis(mercaptomethylthio)ethyl)methane, tetrakis(4,4-bis(mercaptomethylthio)-2-thiabutyl)methane, 3,5,9,11-tetrakis(mercaptomethylthio)-1,13-dimercapto-2,6,8,12-tetrathiatridecane, 3,5,9,11,15,17-hexakis(mercaptomethylthio)-1,19-dimercapto-2,6,8,12,14,18-hexathianonadecane, 9-(2,2-bis(mercaptomethylthio)ethyl)-3,5,13,15-tetrakis(mercaptomethylthio)-1,17-dimercapto-2,6,8,10,12,16-hexathiaheptadecane, 3,4,8,9-tetrakis(mercaptomethylthio)-1,11-dimercapto-2,5,7,10-tetrathiaundecane, 3,4,8,9,13,14-hexakis(mercaptomethylthio)-1,16-dimercapto-2,5,7,10,12,15-hexathiahexadecane, 8-[bis(mercaptomethylthio)methyl]-3,4,12,13-tetrakis(mercaptomethylthio)-1,15-dimercapto-2,5,7,9,11,14-hexathiapentadecane, 4,6-bis[3,5-bis(mercaptomethylthio)-7-mercapto-2,6-dithiaheptylthio]-1,3-dithiane, 4-[3,5-bis(mercaptomethylthio)-7-mercapto-2,6-dithiaheptylthio]-6-mercaptomethylthio-1,3-dithiane, 1,1-bis[4-(6-mercaptomethylthio)-1,3-dithianylthio]-1,3-bis(mercaptomethylthio)propane, 1-[4-(6-mercaptomethylthio)-1,3-dithianylthio]-3-[2,2-bis(mercaptomethylthio)ethyl]-7,9-bis(mercaptomethylthio)-2,4,6,10-tetrathiaundecane, 3-[2-(1,3-dithietanyl)]methyl-7,9-bis(mercaptomethylthio)-1,11-dimercapto-2,4,6,10-tetrathiaundecane, 9-[2-(1,3-dithietanyl)]methyl-3,5,13,15-tetrakis(mercaptomethylthio)-1,17-dimercapto-2,6,8,10,12,16-hexathiaheptadecane, 3-[2-(1,3-dithietanyl)]methyl-7,9,13,15-tetrakis(mercaptomethylthio)-1,17-dimercapto-2,4,6,10,12,16-hexathiaheptadecane, 4,6-bis[4-(6-mercaptomethylthio)-1,3-dithianylthio]-6-[4-(6-mercaptomethylthio)-1,3-dithianylthio]-1,3-dithiane, 4-[3,4,8,9-tetrakis(mercaptomethylthio)-11-mercapto-2,5,7,10-tetrathiaundecyl]-5-mercaptomethylthio-1,3-dithiolane, 4,5-bis[3,4-bis(mercaptomethylthio)-6-mercapto-2,5-dithiahexylthio]-1,3-dithiolane, 4-[3,4-bis(mercaptomethylthio)-6-mercapto-2,5-dithiahexylthio]-5-mercaptomethylthio-1,3-dithiolane, 4-[3-bis(mercaptomethylthio)methyl-5,6-bis(mercaptomethylthio)-8-mercapto-2,4,7-trithiaoctyl]-5-mercaptomethylthio-1,3-dithiolane, 2-{bis[3,4-bis(mercaptomethylthio)-6-mercapto-2,5-dithiahexylthio]methyl}-1,3-dithietane, 2-[3,4-bis(mercaptomethylthio)-6-mercapto-2,5-dithiahexylthio]mercaptomethylthiomethyl-1,3-dithietane, 2-[3,4,8,9-tetrakis(mercaptomethylthio)-11-mercapto-2,5,7,10-tetrathiaundecylthio]mercaptomethylthiomethyl-1,3-dithietane, 2-[3-bis(mercaptomethylthio)methyl-5,6-bis(mercaptomethylthio)-8-mercapto-2,4,7-trithiaoctyl] mercaptomethylthiomethyl-1,3-dithietane, 4-{1-[2-(1,3-dithietanyl)]-3-mercapto-2-thiapropylthio}-5-[1,2-bis(mercaptomethylthio)-4-mercapto-3-thiabutylthio]-1,3-dithiolane, and the like. Any one of them may be used alone, or two or more may be used in combination.

The curable resin composition of the present invention must satisfy the prescribed relationship with regard to:

- the total number (total amount) of (meth)acryloyl groups contained in the (A) polyfunctional (meth)acrylate compound,
- the total number (total amount) of (meth)acryloyl groups in the (B) monofunctional (meth)acrylate compound,
- the total number (total amount) of epoxy groups in the (C) epoxy resin; and
- total number (total amount) of thiol groups in the (D) polyfunctional thiol compound.

Specifically, in the curable resin composition of the present invention, [total number of (meth)acryloyl groups for the (B) monofunctional (meth)acrylate compound + total number of epoxy groups for the (C) epoxy resin] / [total number of thiol groups for the (D) polyfunctional thiol compound] is 0.1 to 0.5, [total number of (meth)acryloyl groups for the (B) monofunctional (meth)acrylate compound] / [total number of thiol groups for the (D) polyfunctional thiol compound] is 0.05 to 0.45, and [total number of epoxy groups for the (C) epoxy resin] / [total number of thiol groups for the (D) polyfunctional thiol compound] is 0.05 to 0.45.

The total number of (meth)acryloyl groups for polyofunctional (meth)acrylate compound is the number of (meth)acryloyl groups (equivalent number) per weight (charged amount) of the polyofunctional (meth)acrylate compound, and it is the quotient of the weight (g) of the polyofunctional (meth)acrylate compound divided by the (meth)acryloyl equivalent weight of that polyofunctional (meth)acrylate compound (the sum of such quotients for each polyofunctional (meth)acrylate compound, if more than one polyofunctional (meth)acrylate compound is included.). The (meth)acryloyl equivalent weight of polyofunctional (meth)acrylate compound is theoretically equal to the number obtained by dividing the molecular weight of the polyofunctional (meth)acrylate compound by the number of acryloyl groups (or methacryloyl groups) in one molecule.

The total number of (meth)acryloyl groups for the monofunctional (meth)acrylate compound can also be determined in the same way as for the polyfunctional (meth)acrylate compound.

The curable resin composition of the present invention preferably contains a polyfunctional (meth)acrylate compound having a (meth)acryloyl equivalent weight of 60 to 300 g/eq, more preferably a polyfunctional (meth)acrylate compound having a (meth)acryloyl equivalent weight of 70 to 250 g/eq, and especially preferably a polyfunctional (meth)acrylate compound having a (meth)acryloyl equivalent weight of 80 to 220 g/eq. [Total number of (meth)acryloyl groups for (A) a polyfunctional (meth)acrylate compound having the (meth)acryloyl equivalent weight of 300 g/eq or less]/[ total number of (meth)acryloyl groups for all the (A) polyfunctional (meth)acrylate compound] is preferably 0.7 to 1, more preferably 0.8 to 1, even more preferably 0.9 to 1, and especially preferably 0.95 to 1. When the (A) polyfunctional (meth) acrylate compound with the (meth)acryloyl equivalent weight of 300 g/eq or less makes up the majority of the (A) polyfunctional (meth)acrylate compound, the curability of the curable resin composition of the present invention is easily improved, and it is easier to obtain a tough cross-linked structure in the cured product provided by this composition.

Preferably, the (A) polyfunctional (meth)acrylate compounds with a (meth)acryloyl equivalent weight of 300 g/eq or less does not have a poly(alkylene glycol) skeleton. In one aspect of the present invention, the curable resin composition of the present invention contains (A) a polyfunctional (meth)acrylate compound having a (meth)acryloyl equivalent weight of 60 to 300 g/eq and without a poly(alkylene glycol) backbone. In this case, adhesion to the adherend is easily imparted to the cured product provided by this composition. As a result, the peel strength of the cured product is easily improved.

In the present description, a poly(alkylene glycol) skeleton refers to a poly(oxyalkylene) chain consisting of two or more oxyalkylene groups, such as a poly(oxyethylene) chain that can be introduced by ethylene oxide (EO) modification and a poly(oxypropylene) chain that can be introduced by propylene oxide (PO) modification.

In contrast, it is not desirable for the (A) polyfunctional (meth)acrylate compound with a (meth)acryloyl equivalent weight of 300 g/eq or less as described above to have a poly(alkylene glycol) skeleton. This is because when the curable resin composition of the present invention contains such an (A) polyfunctional (meth)acrylate compound, it is difficult to impart adhesion to the adherend in the cured product provided by the composition, and the peel strength of the cured product is likely to decrease.

The curable resin composition of the present invention may contain a (A) polyfunctional (meth)acrylate compound having a (meth)acryloyl equivalent weight of 60 to 300 g/eq and a poly(alkylene glycol) skeleton. However, in terms of adhesion reliability, [total number of (meth)acryloyl groups for the (A) polyfunctional (meth)acrylate compound having a (meth)acryloyl equivalent weight of 60 to 300 g/eq and a poly(alkylene glycol) skeleton]/[ total number of (meth)acryloyl groups for all the (A) polyfunctional (meth)acrylate compound] is preferably 0.5 or less, more preferably 0.4 or less, even more preferably 0.3 or less, especially preferably 0.2 or less, and most preferably 0.1 or less. In one aspect of the present invention, this ratio is 0 to 0.5, preferably 0 to 0.4, more preferably 0 to 0.3, especially 0 to 0.2, and most preferably 0 to 0.1.

The total number of epoxy groups for an epoxy resin is the number (equivalent number) of epoxy groups per weight (charged amount) of the epoxy resin, and it is the quotient of the weight (g) of the epoxy resin divided by the epoxy equivalent weight of that epoxy resin (the sum of such quotients for each epoxy resin, if more than one epoxy resin is included.). The actual epoxy equivalent weight can be determined by the method described in JIS K7236. If the epoxy equivalent weight cannot be determined by this method, it can be calculated as the quotient of the molecular weight of the epoxy resin divided by the number of epoxy groups in one molecule of the epoxy resin.

The total number of thiol groups of a polyfunctional thiol is the number of thiol groups (equivalent number) per weight (charged amount) of the polyfunctional thiol, and it is the quotient of the weight (g) of the thiol compound divided by the thiol equivalent weight of that thiol compound (the sum of such quotients for each thiol compound, if more than one thiol compound is included.). The actual thiol equivalent weight can be determined, for example, by determining the thiol value by potentiometry. This method is widely known and is disclosed, for example, in paragraph 0079 of JP 2012-153794 A. If the thiol equivalent weight cannot be determined by this method, it can be calculated as the quotient of the molecular weight of the polyfunctional thiol compound divided by the number of thiol groups in one molecule of the polyfunctional thiol compound.

In conventional UV- and thermo-curable adhesives that do not contain a monofunctional (meth)acrylate compound and an epoxy resin, the amount of polyfunctional (meth)acrylate compound is approximately equivalent to the amount of polyfunctional thiol compound. In contrast, the curable resin composition of the present invention contains a polyfunctional (meth)acrylate compound, a monofunctional (meth)acrylate compound, an epoxy resin, and a polyfunctional thiol compound in an amount ratio where the total number of (meth)acryloyl groups for the polyfunctional (meth)acrylate compound, the total number of (meth)acryloyl groups for the monofunctional (meth)acrylate compound, the total number of epoxy groups for the epoxy resin and the total number of thiol groups for the polyfunctional thiol compound satisfy the above conditions..

When [total number of (meth)acryloyl groups for the (B) monofunctional (meth)acrylate compound + total number of epoxy groups for the (C) epoxy resin] / [total number of thiol groups for the (D) polyfunctional thiol compound] is more than 0.5, the (B) component reacts with the thiol group of the (D) component, destroying the cross-linking point, and the (C) component, which does not react with LTV, increases, resulting in insufficient shear strength of the cured product obtained by UV curing. On the other hand, when [total number of (meth)acryloyl groups for the (B) monofunctional (meth)acrylate compound + total number of epoxy groups for the (C) epoxy resin] / [total number of thiol groups for the (D) polyfunctional thiol compound] is less than 0.1, peel strength of the cured product obtained by UV curing becomes insufficient, and the cured product tends to easily peel off from the adherend.

In the present invention, [total number of (meth)acryloyl groups for the (B) monofunctional (meth)acrylate compound + total number of epoxy groups for the (C) epoxy resin] / [total number of thiol groups for the (D) polyfunctional thiol compound] is preferably 0.25 to 0.5, more preferably 0.3 to 0.45.

When [total number of (meth)acryloyl groups for the (B) monofunctional (meth)acrylate compound] / [total number of thiol groups for the (D) polyfunctional thiol compound] is less than 0.05, it is difficult to achieve low cross-link density, and peel strength tends to be low after UV curing.. When [total number of (meth)acryloyl groups for the (B) monofunctional (meth)acrylate compound] / [total number of thiol groups for the (D) polyfunctional thiol compound] is more than 0.45, cross-link density tends to be low, and shear strength after heat curing and peel strength after UV curing may be low.

In the present invention, [total number of (meth)acryloyl groups for the (B) monofunctional (meth)acrylate compound] / [total number of thiol groups for the (D) polyfunctional thiol compound] is preferably 0.1 to 0.4, more preferably 0.15 to 0.4, and even more preferably 0.15 to 0.35.

(C) Epoxy resin is used together with component (B) and contributes to the development of peel strength after UV curing treatment and shear strength after heat curing treatment. In the present invention, [total number of epoxy groups for the (C) epoxy resin] / [total number of thiol groups for the (D) polyfunctional thiol compound] is preferably 0.05 to 0.40, more preferably 0.05 to 0.35, and even more preferably 0.05 to 0.20.

[Total number of (meth)acryloyl groups for the (B) monofunctional (meth)acrylate compound] : [total number of epoxy groups for the (C) epoxy resin] is preferably 1:0.01 to 1:20, more preferably 1:0.05 to 1:15, even more preferably 1:0.1 to 1:10, especially preferably 1:0.1 to 1:5, and most preferably 1:0.1 to 1:1. When [total number of epoxy groups for the (C) epoxy resin] with respect to [total number of (meth)acryloyl groups for the (B) monofunctional (meth)acrylate compound] is too little, adhesion after UV curing followed by heat curing is likely to be inadequate. On the other hand, when [total number of epoxy groups for the (C) epoxy resin] with respect to [total number of (meth)acryloyl groups for the (B) monofunctional (meth)acrylate compound] is too much, adhesion after UV curing treatment tends to be insufficient.

In the curable resin composition of the present invention, the total amount of the polyfunctional (meth)acrylate compound, the monofunctional (meth)acrylate compound and the epoxy resin is preferably approximately equivalent to the amount of the polyfunctional thiol compound.

In one embodiment of the present invention, it is preferred that [total number of (meth)acryloyl groups for the (A) polyfunctional (meth)acrylate compound + total number of (meth)acryloyl groups for the (B) monofunctional (meth) acrylate compound + total number of epoxy groups for the (C) epoxy resin] / [total number of thiol groups for the (D) polyfunctional thiol compound] is 0.8 to 1.2. When [total number of (meth)acryloyl groups for the (A) polyfunctional (meth) acrylate compound + total number of (meth)acryloyl groups for the (B) monofunctional (meth)acrylate compound + total number of epoxy groups for the (C) epoxy resin] / [total number of thiol groups for the (D) polyfunctional thiol compound] is less than 0.8, share strength tends to be low after UV curing. On the other hand, when [total number of (meth)acryloyl groups for the (A) polyfunctional (meth)acrylate compound + total number of (meth)acryloyl groups for the (B) monofunctional (meth)acrylate compound + total number of epoxy groups for the (C) epoxy resin] / [total number of thiol groups for the (D) polyfunctional thiol compound] is more than 1.2, share strength after heat curing in areas not exposed to UV tends to be low.

In the present invention, [total number of (meth)acryloyl groups for the (A) polyfunctional (meth)acrylate compound + total number of (meth)acryloyl groups for the (B) monofunctional (meth)acrylate compound + total number of epoxy groups for the (C) epoxy resin] / [total number of thiol groups for the (D) polyfunctional thiol compound] is preferably 0.8 to 1.2, more preferably 0.9 to 1.1, and even more preferably 0.95 to 1.1. When this range is between 0.8 and 1.2, the number of unreacted groups is reduced and the properties of the resulting cured product are appropriate.

Also in the present invention, [total number of (meth)acryloyl groups for the (A) polyfunctional (meth)acrylate compound] / [total number of thiol groups for the (D) polyfunctional thiol compound] is preferably 0.4 to 0.9, more preferably 0.4 to 0.8, and even more preferably 0.5 to 0.7. When this range is 0.4 to 0.9, adhesion reliability after UV curing is easily improved.

(E) Photo-radical initiator

The curable resin composition of the present invention contains a photo-radical initiator. The inclusion of a photo-radical initiator makes it possible to temporarily cure the curable resin composition with a short UV irradiation time. Photo-radical initiators that can be used in the present invention are not particularly limited, and known ones can be used. Examples pf photo-radical initiators include 1-hydroxycyclohexylphenyl ketone, 2-hydroxy-2-methyl-1-phenylpropan-1-one, diethoxyacetophenone, 1-(4-isopropylphenyl)-2-hydroxy-2-methylpropan-1-one, 1-(4-dodecylphenyl)-2-hydroxy-2-methylpropan-1-one, 4-(2-hydroxyethoxy)-phenyl(2-hydroxy-2-propyl)ketone, 2-methyl-1-[4-(methylthio)phenyl]-2-morpholinopropan-1-one, benzoin, benzoin methyl ether, benzoin ethyl ether, benzoin isopropyl ether, benzoin n-butyl ether, benzoin phenyl ether, benzyl dimethyl ketal, benzophenone, benzoylbenzoate, methyl benzoylbenzoate, 4-phenylbenzophenone, hydroxybenzophenone, acrylated benzophenone, 4-benzoyl-4'-methyldiphenylsulfide, 3,3'-dimethyl-4-methoxybenzophenone, thioxansone, 2-chlorothioxansone, 2-methylthioxansone, 2,4-dimethylthioxansone, isopropylthioxansone, 2,4-dichlorothioxansone, 2,4-diethylthioxansone, 2,4-diisopropylthioxansone, 2,4,6-trimethylbenzoyl diphenylphosphine oxide, methylphenylglyoxylate, benzyl, camphorquinone, and the like. Any one of them may be used alone, or two or more may be used in combination. The amount of the (E) photo-radical initiator is preferably 0.01 to 10% by mass, more preferably 0.05 to 5% by mass, and even more preferably 0.1 to 3% by mass of the curable resin composition.

(F) Thermal curing accelerator

The curable resin composition of the present invention contains a thermal curing accelerator. The inclusion of a thermal curing accelerator allows the curable resin composition to cure in a short time even under low temperature conditions. Thermal curing accelerators used in the present invention are not particularly limited and known ones can be used. In one aspect of the present invention, the thermal curing accelerator is a basic substance. The thermal curing accelerator is preferably a latent curing catalyst. A latent curing catalyst is a compound that is inactive at room temperature and is activated by heating to function as a curing catalyst. Examples of the latent curing catalyst include imidazole compounds that are solid at room temperature; solid dispersion type amine adduct latent curing catalysts such as reaction products of amine compounds and epoxy compounds (amine-epoxy adduct type latent curing catalysts); reaction products of amine compounds and isocyanate compounds or urea compounds (urea type adduct type latent curing catalysts).

Typical examples of commercially available latent curing catalyst products include, but are not limited to, amine-epoxy adduct-type products (amine adducts) such as Ajicure PN-23 (trade name; Ajinomoto Fine-Techno Co., Inc.), Ajicure PN-40 (trade name; Ajinomoto Fine-Techno Co., Inc.), Ajicure PN-50 (trade name; Ajinomoto Fine-Techno Co., Inc.), Novacure HX-3742 (trade name; Asahi Kasei Corp.), Novacure HX-3721 (trade name; Asahi Kasei Corp.), Novacure HXA9322HP (trade name; Asahi Kasei Corp.), Novacure HXA3922HP (trade name; Asahi Kasei Corp.), Novacure HXA3932HP (trade name; Asahi Kasei Corp.), Novacure HXA5945HP (trade name; Asahi Kasei Corp.), Novacure HXA9382HP (trade name; Asahi Kasei Corp.), Fujicure FXR1121 (trade name; T & K TOKA Co., Ltd.), and the like; and urea adduct products such as Fujicure FXE-1000 (trade name; T & K TOKA Co., Ltd.), Fujicure FXR-1030 (trade name; T & K TOKA Co., Ltd.), and the like. Any one of thermal curing accelerators may be used alone, or two or more may be used in combination. As a thermal curing accelerator, solid-dispersion amine adduct-type latent curing catalysts are preferred from the viewpoint of pot life and curing performance. The amount of the thermal curing accelerator is preferably 0.1 to 20% by mass, more preferably 0.5 to 15% by mass, and even more preferably 1 to 10% by mass of the curable resin composition.

The thermal curing accelerator may be provided in the form of a dispersion dispersed in a polyfunctional epoxy resin. It should be noted that, when the thermal curing accelerator is used in such form, the amount of the polyfunctional epoxy resin in which the thermal curing accelerator is dispersed is also included in the amount of the epoxy resin above present in the curable resin composition of the present invention.

As described above, the problem with conventional UV- and thermo-curable adhesives is that the peel strength of the bonded area in the UV-cured state is insufficient. Such problems are particularly likely to occur when the adherend has relatively low adherability to UV- and thermo-curable adhesives (e.g., adherends made of polyethylene terephthalate (PET) or polybutylene terephthalate (PBT)).

After various studies, the inventors have found that the use of a monofunctional (meth)acrylate compound and an epoxy resin makes it possible to improve such insufficient peel strength of the adhesive sites in the UV-cured state. In addition, shear strength can be maintained.

The cured product can be obtained by subjecting the curable resin composition of the present invention to a curing treatment that includes:

- curing treatment by ultraviolet (UV) irradiation (UV curing treatment), and/or
- curing treatment by heating (thermal curing treatment).

When the above UV curing and thermal curing treatments are performed together, it may be a two-step process where the UV curing treatment is followed by the thermal curing treatment.

The following reactions (1) and (2) proceed under UV irradiation for the above UV curing treatment:

(1) addition of a thiol group to a double bond in a (meth)acryloyl group by radical reaction;
(2) radical polymerization of the double bond in the (meth)acryloyl group (homopolymerization).

Reactions of epoxy groups do not occur under UV irradiation.

On the other hand, the following reactions (3) and (4) proceed under heating for the above thermal curing treatment:

(3) thermal addition of a thiol group to a double bond in a (meth)acryloyl group;
(4) ring-opening nucleophilic addition of a thiol group to an epoxy group.

Radical polymerization (homopolymerization) of the double bond in the (meth)acryloyl group does not occur under heating.

When a polyfunctional (meth)acrylate compound and a polyfunctional thiol compound are subjected to the above UV and thermal curing treatments in the presence of a photo-radical initiator and a thermal curing accelerator, the followings occur:

- the reaction (1) between the polyfunctional (meth)acrylate compound and the polyfunctional thiol compound;
- the reaction (2) between the polyfunctional (meth)acrylate compounds; and
- the reaction (3) between the polyfunctional (meth)acrylate compound and the polyfunctional thiol compound.

On the other hand, when the curable resin composition of the present invention is subjected to the above UV curing and thermal curing treatments, in addition to the above reactions, the followings occur:

- the reaction (1) between the monofunctional (meth)acrylate compound and the polyfunctional thiol compound;
- the reaction (2) between the polyfunctional (meth)acrylate compound and the monofunctional (meth)acrylate compound;

- the reaction (2) between the monofunctional (meth)acrylate compounds;
- the reaction (3) between the monofunctional (meth)acrylate compound and the polyfunctional thiol compound; and
- the reaction (4) between the epoxy resin and the polyfunctional thiol compound.

Of these reactions in the presence of the monofunctional (meth)acrylate compound and the epoxy resin, the reaction (1) between the monofunctional (meth)acrylate compound and the polyfunctional thiol compound, the reaction (3) between the monofunctional (meth)acrylate compound and the polyfunctional thiol compound, and the reaction (2) between the polyfunctional (meth)acrylate compound and the monofunctional (meth)acrylate compound inhibit the increase in crosslink density of the cured product. The reactions (1) and (3) cap the thiol groups in the polyfunctional thiol compound and inhibit the formation of new cross-links. The reaction (2) extends the polymer chains and widens the spacing between cross-links. The cured product given by the curable resin composition of the present invention is a polymeric material containing cross-linking. However, as mentioned above, the use of a monofunctional (meth)acrylate compound and an epoxy resin prevents an increase in crosslink density during UV and thermal curing treatments. As a result, the polymer has a lower crosslink density than cured products obtained from conventional curable resin compositions that do not use a monofunctional (meth)acrylate compound and an epoxy resin.

On the other hand, the reaction (4) between the epoxy resin and the polyfunctional thiol compound causes ring opening of the epoxy groups in the epoxy resin to produce hydroxyl groups. The hydroxyl groups can contribute to improving the adhesive strength of the cured product to the adherend, and thus preventing the cured product from peeling off from the adherend.

When the epoxy resin is a monofunctional epoxy resin, the thiol groups in the polyfunctional thiol compound are capped by this reaction (4), and the formation of new crosslinks is inhibited. As a result, the reaction (4) does not increase the crosslink density of the cured product. On the other hand, if the epoxy resin is a polyfunctional epoxy resin, new crosslinks can theoretically be formed by this reaction (4). In practice, however, new crosslinks are unlikely to form because the UV curing treatment forms a polymer and restricts the movement of the epoxy resin in the system.

The cured product given by the curable resin composition of the present invention has a lower crosslink density than cured products given by conventional UV- and thermo-curable adhesives. The low crosslink density of the cured product is thought to contribute to the improved bond strength, especially peel strength, after UV irradiation when the curable resin composition of the present invention is used as an adhesive.

Some of the peel stresses applied to the two parts bonded through the cured adhesive are dissipated as the cured product deforms. The cured product provided by the curable resin composition of the present invention is more easily deformed by peel stress because of its lower crosslink density and flexibility compared to cured products provided by conventional UV- and thermo-curable adhesives. This is believed to result in more dissipation of peel stress and improved peel strength after UV irradiation.

On the other hand, shear stress is another stress that is important in the peeling and/or misalignment of parts due to impact, etc., mentioned above. As the crosslink density (flexibility) of the cured adhesive decreases, the shear strength at the bonding site by that adhesive tends to decrease. In fact, the shear strength after UV irradiation at bonding sites with the curable resin composition of the present invention may be lower than that at bonding sites with conventional UV- and thermo-curable adhesives. However, this shear strength, in relation to the flexibility of the cured product provided by the curable resin composition of the present invention, is sufficient to prevent peeling and/or misalignment of parts due to impacts that may occur under normal conditions.

The curable resin composition of the present invention also has excellent adhesive strength (shear strength) even when subjected to heat treatment only. Therefore, the curable resin composition of the present invention is particularly useful when the area of the cured product in contact with the adherend by UV irradiation is small.

The curable composition of the present invention may, if desired, contain optional components other than the above components (A) through (F), such as those described below, as needed.

- Filler

The curable resin composition of the present invention may contain a filler, especially a silica filler and/or a talc filler, if desired. A filler can be added to improve the thermal cycle resistance of cured products obtained by curing the curable resin composition of the present invention. The addition of a filler improves thermal cycling resistance because the linear expansion coefficient of the cured product is reduced, i.e., the expansion and contraction of the cured product due to thermal cycling is suppressed. Shrinkage during curing is also suppressed.

When a filler is used, its average particle diameter is preferably 0.1 to 10 $\mu$m. In the present description, the average particle diameter refers to the volume-based median diameter (d50) measured by the laser diffraction method in accordance with ISO-13320 (2009), unless otherwise noted.

When a filler is used, its content is preferably 1 to 70% by mass and more preferably 5 to 60% by mass, relative to the total mass of the curable resin composition.

Any one of fillers may be used alone, or two or more may be used in combination. Specific examples of fillers other than silica and talc fillers include, but are not limited to, alumina fillers, calcium carbonate fillers, polytetrafluoroethylene (PTFE) fillers, silicone fillers, acrylic fillers, and styrene fillers.

In the present invention, fillers may also be surface treated.

- Stabilizer

The curable resin composition of the present invention may contain a stabilizer if desired. Stabilizers can be added to the curable resin composition of the present invention to improve their storage stability and extend their pot life. Various stabilizers known as stabilizers for one-component adhesives can be used. At least one selected from the group consisting of liquid boric acid ester compounds, aluminum chelates and organic acids is preferred due to its effectiveness in improving storage stability.

Examples of the liquid boric acid ester compounds include 2,2'-oxybis(5,5'-dimethyl-1,3,2-oxaborinane), trimethylborate, triethylborate, tri-n-propylborate, triisopropylborate, tri-n-butylborate, tripentylborate, triallylborate, trihexylborate, tricyclohexylborate, trioctylborate, trinonylborate, tridecylborate, tridododecylborate, trihexadecylborate, trioctadecylborate, tris(2-ethylhexyloxy)borane, bis(1,4,7,10-tetraoxaundecyl)(1,4,7,10,13-pentaoxatetradecyl)(1,4,7-trioxaundecyl)borane, tribenzylborate, triphenylborate, tri-o-tolylborate, tri-m-tolylborate, triethanolamineborate, and the like. Liquid boric acid ester compounds are preferred because they are liquid at room temperature (25°C), which keeps the composition viscosity low. For example, Aluminum Chelate A (from Kawaken Fine Chemicals Co., Ltd.) can be used as aluminum chelate. Barbituric acid, for example, may be used as an organic acid.

When the curable resin composition of the present invention contains a stabilizer, the amount of the stabilizer is preferably 0.01 to 10 parts by mass, more preferably 0.05 to 5 parts by mass, and even more preferably 0.1 to 3 parts by mass with respect to the total 100 parts by mass of components (A) through (F).

- Coupling agent

The curable resin composition of the present invention may contain a coupling agent if desired. The addition of a coupling agent, especially a silane coupling agent, is preferred from the viewpoint of improving adhesive strength. Silane coupling agents are organosilicon compounds having two or more different functional groups in their molecules, including functional groups that can chemically bond with inorganic materials and organic materials. In general, the functional groups that can chemically bond to inorganic materials are hydrolysable silyl groups, and silyl groups, including alkoxy groups, especially methoxy and/or ethoxy groups, are used as this functional group. Vinyl, epoxy, (meth)acryl, styryl, unsubstituted or substituted amino, mercapto, ureido, and isocyanate groups are used as functional groups that can chemically bond with organic materials. Various silane coupling agents with the aforementioned functional groups can be used as coupling agents. Specific examples of silane coupling agents include 3-glycidoxypropyltrimethoxysilane, 3-aminopropyltrimethoxysilane, vinyltrimethoxysilane, 3-triethoxysilyl-N-(1,3-dimethylbutylidene)propylamine, 2-(3,4-epoxycyclohexyl)ethyltrimethoxysilane, p-styryltrimethoxysilane, 3-methacryloxypropyl methyltrimethoxysilane, 3-acryloxypropyltrimethoxysilane, 8-glycidoxyoctyltrimethoxysilane, 3-ureidopropyltriethoxysilane, 3-mercaptopropyltrimethoxysilane, bis(triethoxysilylpropyl)tetrasulfide, 3-isocyanate propyltriethoxysilane, etc. Any one of silane coupling agents may be used alone, or two or more may be used in combination.

Silane coupling agents (including those used for surface treatment of the above fillers) may have reactive functional groups such as (meth)acryloyl groups or epoxy groups. In the present invention, however, silane coupling agents are not included in components (A) through (F).

When the curable resin composition of the present invention contains a coupling agent, the amount of the coupling agent is preferably from 0.01 to 10 parts by mass, more preferably from 0.1 to 5 parts by mass, relative to the total 100 parts by mass of components (A) through (F) from the viewpoint of improving adhesive strength.

- Thixotropic agent

The curable resin composition of the present invention may contain a thixotropic agent if desired. The thixotropic agents used in the present invention are not particularly limited and can be any known thixotropic agent. Examples of thixotropic agents used in the present invention include, but are not limited to, silica. Silica may be natural silica (silica stone, quartz, etc.) or synthetic silica. Synthetic silica can be synthesized by any method, including dry and wet methods.

The thixotropic agent may also be surface treated with a surface treatment agent (e.g., polydimethylsiloxane). In the present invention, it is preferred that at least a portion of the thixotropic agent is surface treated. The average diameter of the primary particles of the thixotropic agent is preferably 5 to 50 nm.

The curable resin composition of the present invention preferably contains a thixotropic agent in an amount of 0.1 to 30% by mass, more preferably 1 to 20% by mass, and especially preferably 1 to 15% by mass relative to the total mass of the curable resin composition.

- Other additives

The curable resin composition of the present invention may, if desired, further contain other additives, such as carbon black, titanium black, an ion trap agent, a leveling agent, an antioxidant, a defoaming agent, a viscosity adjuster, a flame retardant, a colorant, a solvent, and the like, to the extent that the purpose of the present invention is not compromised. The type and amount of each additive is as usual.

The method of producing the curable resin composition of the present invention is not limited. For example, components (A) to (F), and other additives, if necessary, can be introduced simultaneously or separately into an appropriate mixing machine and mixed by stirring while melting by heating if necessary, to obtain a uniform composition as the curable resin composition of the present invention. The mixing machine is not limited, and can be a ricer, Henschel mixer, 3-roll mill, ball mill, planetary mixer, bead mill, and the like, equipped with an agitator and heating device. A combination of these devices may also be used as appropriate.

The curable resin composition thus obtained can be converted to a cured product by subjecting it to UV and/or thermal curing treatment as described earlier.

UV curing can be performed by making the curable resin composition of the invention receive a sufficient integrated amount of UV light at room temperature. The irradiation intensity is preferably from 100 to 1000 mW/cm$^2$, and more preferably from 1000 to 9000 mW/cm$^2$. The wavelength of the UV light is preferably 315-450 nm, more preferably 340-430 nm, and especially preferably 350-380 nm. The UV light source is not limited, and gallium nitride-based UV-LEDs and the like can be used. The integrated light intensity of UV light received by the curable resin composition is preferably 200 mJ/cm$^2$ or more, more preferably 500 mJ/cm$^2$ or more, even more preferably 1000 mJ/cm$^2$ or more, and especially preferably 2000 mJ/cm$^2$ or more. There is no particular limit to the upper limit of the integrated light intensity, which can be set freely within the range that does not impair the purpose of the present invention. The integrated light intensity of ultraviolet light can be measured using measurement equipment commonly used in the field, such as ultraviolet light meters and photodetectors. For example, the integrated light intensity in the wavelength range of ultraviolet light (310-390 nm) with a central wavelength of 365 nm can be measured using a UV integrated light meter (UIT-250, available from Ushio Inc.) and a photodetector (UVD-S365, available from Ushio Inc.).

Thermal curing, on the other hand, can be performed by heating the curable resin composition of the invention after UV curing under appropriate conditions. This heating is preferably performed at 60-120°C, more preferably at 60-100°C, and especially preferably at 70-90°C. This heating is preferably performed for 5 to 180 minutes, more preferably for 10 to 120 minutes, and especially preferably for 20 to 70 minutes.

When two parts (adherends) are bonded by UV irradiation using the curable resin composition of the present invention, peeling and/or misalignment of the parts is unlikely to occur even when the resulting assembly is subjected to peeling stress. This is because the flexibility of the cured product, with its low crosslink density, makes it more prone to dissipation of peel stresses. The curable resin composition of the present invention exhibits sufficient adhesive strength not only when subjected to the two-step curing treatment as described above, but also when subjected to thermal curing treatment alone. The curable resin composition of the present invention, when subjected to a two-step curing process, gives a flexible cured product with a low crosslink density.

The curable resin composition of the present invention can be used, for example, as adhesives or raw materials thereof for joining semiconductor devices containing various electronic components or parts comprising electronic components.

In the present invention, an adhesive containing the curable resin composition of the present invention is also provided. The adhesive is suitable, for example, for fixing modules and electronic components.

Also provided in the present invention is a cured product obtained by curing the curable resin composition or the adhesive of the present invention. In the present invention, there is also provided a semiconductor device including the cured product of the present invention. In the present invention, there is also provided a sensor module including the semiconductor device of the present invention.

Examples

Hereinbelow, the present invention will be described in more detail with reference to the following Examples, which should not be construed as limiting the scope of the present invention. In the following examples, parts and percentages refer to parts by mass and percentages by mass, unless otherwise noted.

Examples 1 to 23, and Comparative Examples 1 to 10

Each of curable resin compositions was prepared by mixing each of the components in the amounts according to the formulations shown in Table 1 using a three-roll mill. In Table 1, the amount of each component is expressed in parts by mass (unit: g).

- (A) Polyfunctional (meth)acrylate compound

In the examples and comparative examples, the compounds used as polyfunctional (meth)acrylate compounds are as follows.

(A-1): Dimethylol tricyclodecanediacrylate (trade name: Light Acrylate DCP-A, available from Kyoeisha Chemical Co., Ltd., (meth)acryloyl equivalent weight: 152 g/eq)

(A-2): 2-(2-acryloyloxy-1,1-dimethylethyl)-5-acryloyloxymethyl-5-ethyl-1,3-dioxane (trade name: KAYARAD R-604, Nippon Kayaku Co., Ltd., (meth)acryloyl equivalent weight: 163 g/eq)

(A-3): Polyether urethane acrylate (trade name: UN-6200, available from Negami Chemical Industrial Co., Ltd., (meth)acryloyl equivalent weight: 3250 g/eq)

(A-4): Ditrimethylolpropane tetraacrylate (trade name: EBECRYL 140, available from DAICEL-ALLNEX LTD., (meth)acryloyl equivalent weight: 117 g/eq)

[0100]    - (B) Monofunctional (meth)acrylate compound

The compounds used as the (B) monofunctional (meth)acrylate compound in the examples and comparative examples are as follows.

(B-1): Isobornyl acrylate (trade name: Light Acrylate IBXA, available from Kyoeisha Chemical Co., Ltd., (meth)acryloyl equivalent weight: 208 g/eq)

(B-2): m-Phenoxybenzyl acrylate (trade name: light acrylate POB-A, available from Kyoeisha Chemical Co., Ltd., (meth)acryloyl equivalent weight: 254 g/eq)

(B-3): 4-t-butylcyclohexyl acrylate (trade name: Kohsilmer® TBCHA®, available from KJ Chemicals Corporation, (meth)acryloyl equivalent weight: 210 g/eq)

(B-4): Dicyclopentanyl acrylate (trade name: FA513AS, available from Showa Denko Materials Co., Ltd., (meth)acryloyl equivalent weight: 206 g/eq)

(B-5): 2-(o-phenylphenoxy)ethyl acrylate (trade name: HRD-01, available from Nisshoku Techno Fine Chemical Co., Ltd., (meth)acryloyl equivalent weight: 268 g/eq)

[0102]    - (B') High molecular weight monofunctional (meth)acrylate compound

The compounds used as (B') a high molecular weight monofunctional (meth)acrylate compound in the examples and comparative examples are as follows.

(B-1'): Methoxy-polyethylene glycol acrylate (trade name: Light Acrylate 130A, available from Kyoeisha Chemical Co., Ltd., (meth)acryloyl equivalent weight: 482 g/eq)

- (C) Epoxy resin

The compounds used as the (C) epoxy resin in the examples and comparative examples are as follows.

(C-1): Bisphenol A epoxy resin (trade name: JER834, available from Mitsubishi Chemical Group Corporation; epoxy equivalent weight: 250 g/eq)

(C-2): Dicyclopentadiene epoxy resin (trade name: EPICLON HP-7200L, available from DIC Corporation, epoxy equivalent weight: 246 g/eq)

(C-3): Tri(epoxypentyl)isocyanurate (trade name: TEPIC-VL, available from Nissan Chemical Corporation, epoxy equivalent weight: 135 g/eq)

- (D) Polyfunctional thiol compound

The compounds used as the (D) polyfunctional thiol compound in the examples and comparative examples are as follows.

(D-1): Pentaerythritol tetrakis(3-mercaptopropionate) (trade name: PEMP, available from SC Organic Chemical Co., Ltd., thiol equivalent weight: 122 g/eq)

(D-2): Pentaerythritol tripropanethiol (trade name: PEPT, available from SC Organic Chemical Co., Ltd., thiol equivalent weight: 124 g/eq)

(D-3): 1,3,4,6-Tetrakis(3-mercaptopropyl)glycoluril (trade name: C3 TS-G, available from Shikoku Chemicals Corporation, thiol equivalent weight: 114 g/eq)

- (E) Photo-radical initiator

(E-1): 1-hydroxy-cyclohexyl-phenyl-ketone (trade name: Omnirad 184, available from IGM Resins B.V.)
(E-2): 2,4,6-trimethylbenzoyl diphenylphosphine oxide (trade name: Omnirad TPO, available from IGM Resins B.V.)

- (F) Thermal curing accelerator

In the examples and comparative examples, the compounds used as the (F) thermal curing accelerator are as follows.

(F-1): Amine-epoxy adduct-type latent curing catalyst 1 (trade name: Fujicure FXR1121, available from T & K TOKA Co., Ltd.)
(F-2): Amine-epoxy adduct-type latent curing catalyst 2 (trade name: Ajicure PN-23, available from Ajinomoto Fine-Techno Co., Inc.)

- (G) Other additives

(g1) Filler

The compounds used as a filler in the examples and comparative examples are as follows.

(G-1): Synthetic spherical silica (trade name: SE2200SEE, available from Admatechs Company Limited)
(G-2): Fine-particle talc (trade name: 5000 PJ, available from Matsumura Sangyo Co., Ltd.)

(g2) Stabilizer

In the examples and comparative examples, the compounds used as a stabilizer are as follows.

(G-3): N-nitroso-N-phenylhydroxylamine aluminum salt (available from FUJIFILM Wako Pure Chemical Corporation)
(G-4): Triisopropylborate (available from Tokyo Chemical Industry Co., Ltd.)

(g3) Thixotropic agent

In the examples and comparative examples, the compounds used as a thixotropic agent are as follows.
(G-5): Fumed silica (trade name: CAB-O-SIL® TS-720, available from Cabot Corporation, surface treated with polydimethylsiloxane)
The symbols in the tables for "equivalent number calculation" represent the following.

[(A)+(B)+(C)]/(D): [total number of (meth)acryloyl groups for the (A) polyfunctional (meth)acrylate compound + total number of (meth)acryloyl groups for the (B) monofunctional (meth)acrylate compound + total number of epoxy groups for the (C) epoxy resin] / [total number of thiol groups for the (D) polyfunctional thiol compound] (B)/(D): [total number of (meth)acryloyl groups for the (B) monofunctional (meth)acrylate compound] / [total number of thiol groups for the (D) polyfunctional thiol compound] (C)/(D): [total number of epoxy groups for the (C) epoxy resin] / [total number of thiol groups for the (D) polyfunctional thiol compound] [(B) + (C)] / (D): [total number of (meth)acryloyl groups for the (B) monofunctional (meth)acrylate compound + total number of epoxy groups for the (C) epoxy resin] / [total number of thiol groups for the (D) polyfunctional thiol compound] (A)/(D): [total number of (meth)acryloyl groups for the (A) polyfunctional (meth)acrylate compound] / [total number of thiol groups for the (D) polyfunctional thiol compound]

(Evaluation of peel strength (90° peel test) after UV curing)

On a 7.6 cm x 2.6 cm x 1.5 mm glass plate, 0.1 g of each curable resin composition was applied in three straight lines, 5 cm in length and in close contact with each other, using JR2400N, a robot for dispensing available from San-Ei Tech Ltd. A 12cm x 1cm x 0.15mm polyimide film with a hole at one end was placed on the applied curable resin composition to prevent air bubbles. The position of the polyimide film relative to the glass plate was adjusted so that the shorter side of the polyimide film without holes was aligned with the shorter side of one of the glass plates. The position of the polyimide film was also adjusted so that a straight line passing through the center of both short sides of the polyimide film approximately overlapped the straight line passing through the center of both short sides of the glass plate. The force was then applied evenly over the polyimide film so that the curable resin composition spread to the width of the polyimide film without protruding from the polyimide film and glass. The thickness of the curable resin composition at this point was about 0.2 mm.

The curable resin composition is then temporarily cured by UV irradiation from the glass surface using a UV LED irradiation device AC475 available from Excelitas Technologies Corp at an integrated light intensity of 2000 mJ/cm$^2$ (measured with UIT-250 available from USHIO INC. (connected to UVD-365 light receiver)) to bond the glass plate and the polyimide film.

The above glass plate was fixed horizontally on a precision load measuring instrument (available from Aikoh Engineering Co., Ltd., model number: 1605HTP). The polyimide film glued to the glass plate above was connected to the above precision load measuring instrument with a string tied to a hole in it (at the end not glued to the glass plate).

The polyimide film was subjected to a tensile load at a rate of 100 mm/min through the above string by the above precision load measuring instrument at 23°C. In this case, the position to fix the glass plate was adjusted beforehand, so that the cured product on the glass plate (curable resin composition temporarily cured by UV irradiation) was subjected to a tensile load applied vertically to the polyimide film at the point where it reached the closest point to the hole in the polyimide film.

The change in tensile load was recorded from the start of the tensile load application until the polyimide film was completely separated from the glass plate, and the maximum value of the tensile load was defined as the peel strength. The peel strength of each composition is the average of multiple (n=4) measurements. The results are shown in Table 1.

The peel strength after UV curing is preferably 1.7 N or more, and more preferably 2.0 N or more. Peel strength was evaluated as "x" if the measured value is less than 1.7 N, "O" if the measured value is 1.7 N and more and less than 2.1 N, and "◎" if the measured value is 2.1 N or more.

(Evaluation of shear strength after UV curing)

On a stainless steel (SUS304) plate of 3 cm × 4 cm × 0.1 mm, the curable resin composition was printed to form a circle of 2 mmΦ by stencil printing. The composition after printing was 2 mm Φ and 0.1 mm thick. Alumina chips, each 1.5 mm x 3 mm x 0.5 mm, were placed on the printed curable resin composition with the 1.5 mm x 3 mm side down.

The curable resin composition was subjected to UV curing treatment by UV irradiation using a UV LED irradiation device AC475 available from Excelitas Technologies Corp at an integrated light intensity of 2000 mJ/cm$^2$ (measured with a UIT-250 (connected to a UVD-365 light receiver) available from Ushio Inc.) to bond (temporarily fix) the alumina chips to the stainless steel plate.

Upon completion of the UV curing treatment, the shear strength (unit: N) was measured for each adhesion site using a table-top universal testing machine (1605HTP available from Aikoh Engineering Co., Ltd.). The shear strength of each composition after UV curing is the average of multiple (n=10) measurements. The results are shown in Table 1.

The shear strength after UV curing is preferably 15 N or more, and more preferably 20 N or more. The shear strength after UV curing was evaluated as "x" if the measured value is less than 15N, "O" if the measured value is 15N or more and less than 20N, and "◎" if the measured value is 20N or more.

(Evaluation of shear strength after heat curing)

The curable resin compositions printed on stainless steel sheets (with alumina chips placed on top of them) as described in the section "Evaluation of Share Strength after UV Curing" above were subjected to thermal curing treatment by heating at 80°C for 60 minutes in an air dryer, to bond alumina chips to stainless steel plates. Upon completion of the heat curing treatment, the shear strength (unit: N) was measured for each adhesion site using a table-top universal testing machine (1605HTP available from Aikoh Engineering Co., Ltd.). The shear strength of each composition due to heat curing is the average of multiple (n=10) measurements, respectively. The results are shown in Table 1.

The shear strength after heat curing is preferably 30 N or more, and more preferably 50 N or more. The shear strength after heat curing was evaluated as "x" when the measured value is less than 30 N, as "O" when the measured value is 30 N or more and less than 50 N, and as "◎" when the measured value is 50 N or more.

(Evaluation of shear strength after UV + heat curing)

The same procedure as "Evaluation of shear strength after heat curing" above was repeated, except for using the UV cured product (whereby the alumina chips are bonded (temporarily fixed) to the stainless steel plate) obtained by UV curing treatment by UV irradiation as described in the section "Evaluation of shear strength after UV curing" above, instead of the curable resin composition printed on a stainless steel plate (with an alumina chip placed on top of it). The shear strength of each composition by UV + heat curing was evaluated by calculating the average of multiple (n=10) measurements, respectively.

The shear strength by UV + heat curing was sufficiently high for all compositions (Examples 1-23 and Comparative Examples 1-10) and improved over the shear strength after UV curing.

[Table 1-1]

Table 1

| | | Example 1 | Example 2 | Example 3 | Example 4 | Example 5 | Example 6 | Example 7 | Example 8 |
|---|---|---|---|---|---|---|---|---|---|
| (A) | (A-1) | 41.37 | 34.60 | 26.21 | | 23.11 | | 25.43 | 26.61 |
| | (A-2) | | | | 32.79 | | | | |
| | (A-3) | | | | | 10.00 | | | |
| | (A-4) | | | | | | 20.99 | | |
| (B) | (B-1) | 3.86 | 7.48 | 11.96 | 8.97 | 10.54 | 19.85 | | |
| | (B-2) | | | | | | | 17.70 | |
| | (B-3) | | | | | | | | 14.44 |
| | (B-4) | | | | | | | | |
| | (B-5) | | | | | | | | |
| (B') | (B-1') | | | | | | | | |
| (C) | (C-1) | 4.64 | 8.99 | 14.37 | 10.78 | 12.67 | 7.95 | 10.46 | 10.94 |
| | (C-2) | | | | | | | | |
| | (C-3) | | | | | | | | |
| (D) | (D-1) | 37.73 | 36.54 | 35.06 | 35.06 | 31.29 | 38.81 | 34.01 | 35.60 |
| | (D-2) | | | | | | | | |
| | (D-3) | | | | | | | | |
| (E) | (E-1) | 0.20 | 0.20 | 0.20 | 0.20 | 0.20 | 0.20 | 0.20 | 0.20 |
| | (E-2) | | | | | | | | |
| (F) | (F-1) | 2.00 | 2.00 | 2.00 | 2.00 | 2.00 | 2.00 | 2.00 | 2.00 |
| | (F-2) | | | | | | | | |
| (g1) | (G-1) | | | | | | | | |
| (g2) | (G-2) | | | | | | | | |
| | (G-3) | | | | | | | | |
| | (G-4) | 0.20 | 0.20 | 0.20 | 0.20 | 0.20 | 0.20 | 0.20 | 0.20 |
| (g3) | (G-5) | 10.00 | 10.00 | 10.00 | 10.00 | 10.00 | 10.00 | 10.00 | 10.00 |

20

(continued)

Table 1

| | | | Example 1 | Example 2 | Example 3 | Example 4 | Example 5 | Example 6 | Example 7 | Example 8 |
|---|---|---|---|---|---|---|---|---|---|---|
| | Total | | 100 | 100 | 100 | 100 | 100 | 100 | 100 | 100 |
| Equivalent num-ber calculation | [(A)+(B)+(C)]/(D) | | 1.000 | 1.000 | 1.000 | 1.000 | 1.000 | 1.003 | 1.000 | 0.986 |
| | (B)/(D) | | 0.060 | 0.120 | 0.200 | 0.150 | 0.198 | 0.300 | 0.250 | 0.236 |
| | (C)/(D) | | 0.060 | 0.120 | 0.200 | 0.150 | 0.198 | 0.100 | 0.150 | 0.150 |
| | [(B)+(C)]/(D) | | 0.120 | 0.240 | 0.400 | 0.300 | 0.395 | 0.400 | 0.400 | 0.386 |
| | (A)/(D) | | 0.880 | 0.760 | 0.600 | 0.700 | 0.605 | 0.603 | 0.600 | 0.600 |
| Evaluation results | Peel strength (UV) | Measured value (N) | 2.1 | 5.5 | 3.9 | 4.0 | 2.8 | 2.8 | 2.8 | 5.0 |
| | | Evaluation | ◎ | ◎ | ◎ | ◎ | ◎ | ◎ | ◎ | ◎ |
| | Share strength (UV) | Measured value (N) | 33 | 32 | 21 | 40 | 19 | 24 | 21 | 32 |
| | | Evaluation | ◎ | ◎ | ◎ | ◎ | ○ | ◎ | ◎ | ◎ |
| | Share strength (heat) | Measured value (N) | 58 | 107 | 119 | 89 | 89 | 76 | 55 | 57 |
| | | Evaluation | ◎ | ◎ | ◎ | ◎ | ◎ | ◎ | ◎ | ◎ |

[Table 1-2]

| Table 1 (Continued) | | | Example 9 | Example 10 | Example 11 | Example 12 | Example 13 | Example 14 | Example 15 | Example 16 |
|---|---|---|---|---|---|---|---|---|---|---|
| (A) | | (A-1) | 26.37 | 25.34 | 29.20 | 29.88 | 28.85 | 28.76 | 24.59 | 26.21 |
| | | (A-2) | | | | | | | | |
| | | (A-3) | | | | | | | | |
| | | (A-4) | | | | | | | | |
| (B) | | (B-1) | | | 11.42 | 6.81 | 6.07 | 6.06 | 19.83 | 11.96 |
| | | (B-2) | | | | | | | | |
| | | (B-3) | | | | | | | | |
| | | (B-4) | 11.79 | | | | | | | |
| | | (B-5) | | 14.743 | | | | | | |
| (B') | | (B-1') | | | | | | | | |
| (C) | | (C-1) | 14.31 | 13.753 | | | 18.25 | 18.20 | 7.94 | 14.37 |
| | | (C-2) | | | 13.50 | | | | | |
| | | (C-3) | | | | 11.05 | | | | |
| (D) | | (D-1) | 35.13 | 33.76 | 33.48 | 39.86 | 17.21 | | 35.24 | 35.06 |
| | | (D-2) | | | | | | 17.29 | | |
| | | (D-3) | | | | | 17.21 | 17.29 | | |
| (E) | | (E-1) | 0.20 | 0.20 | 0.20 | 0.20 | 0.20 | 0.20 | | 0.20 |
| | | (E-2) | | | | | | | 0.20 | |
| (F) | | (F-1) | 2.00 | 2.00 | 2.00 | 2.00 | 2.00 | 2.00 | 2.00 | |
| | | (F-2) | | | | | | | | 2.00 |
| (g1) | | (G-1) | | | | | | | | |
| | | (G-2) | | | | | | | | |
| (g2) | | (G-3) | | | | | | | | |
| | | (G-4) | 0.20 | 0.20 | 0.20 | 0.20 | 0.20 | 0.20 | 0.20 | 0.20 |
| (g3) | | (G-5) | 10.00 | 10.00 | 10.00 | 10.00 | 10.00 | 10.00 | 10.00 | 10.00 |

| Table 1 (Continued) | | | Example 9 | Example 10 | Example 11 | Example 12 | Example 13 | Example 14 | Example 15 | Example 16 |
|---|---|---|---|---|---|---|---|---|---|---|
| Total | | | 100 | 100 | 100 | 100 | 100 | 100 | 100 | 100 |
| Equivalent number calculation | [(A)+(B)+(C)]/(D) | | | | 1.100 | 0.952 | 1.000 | 1.000 | 1.000 | 1.000 |
| | (B)/(D) | | 0.000 | 0.000 | 0.200 | 0.100 | 0.100 | 0.100 | 0.330 | 0.200 |
| | (C)/(D) | | 0.199 | 0.199 | 0.200 | 0.251 | 0.250 | 0.250 | 0.110 | 0.200 |
| | [(B)+(C)]/(D) | | 0.199 | 0.199 | 0.400 | 0.351 | 0.350 | 0.350 | 0.440 | 0.400 |
| | (A)/(D) | | 0.602 | 0.602 | 0.700 | 0.602 | 0.650 | 0.650 | 0.560 | 0.600 |
| Evaluation results | Peel strength (UV) | Measured value (N) | 3.6 | 2.0 | 4.6 | 2.5 | 6.8 | 2.0 | 5.4 | 3.9 |
| | | Evaluation | ◎ | ◎ | ◎ | ◎ | ◎ | ○ | ◎ | ◎ |
| | Share strength (UV) | Measured value (N) | 34 | 21 | 22 | 18 | 46 | 25 | 22 | 24 |
| | | Evaluation | ◎ | ◎ | ◎ | ◎ | ◎ | ◎ | ◎ | ◎ |
| | Share strength (heat) | Measured value (N) | 86 | 79 | 107 | 64 | 108 | 84 | 45 | 104 |
| | | Evaluation | ◎ | ◎ | ◎ | ◎ | ◎ | ◎ | ○ | ◎ |

[Table 1-3]

Table 1 (Continued)

| | | Example 17 | Example 18 | Example 19 | Example 20 | Example 21 | Example 22 | Example 23 | Com. Ex. 1 |
|---|---|---|---|---|---|---|---|---|---|
| (A) | (A-1) | 26.21 | 26.28 | 29.20 | 26.21 | 26.21 | 29.10 | 27.93 | 48.60 |
| | (A-2) | | | | | | | | |
| | (A-3) | | | | | | | | |
| | (A-4) | | | | | | | | |
| (B) | (B-1) | 11.96 | 11.98 | 13.32 | 11.96 | 11.96 | 8.53 | 12.56 | |
| | (B-2) | | | | | | | | |
| | (B-3) | | | | | | | | |
| | (B-4) | | | | | | | | |
| | (B-5) | | | | | | | | |
| (B') | (B-1') | | | | | | | | |
| (C) | (C-1) | 14.37 | 14.40 | 16.01 | 14.37 | 14.37 | 10.25 | 15.09 | |
| | (C-2) | | | | | | | | |
| | (C-3) | | | | | | | | |
| (D) | (D-1) | 35.06 | 35.14 | 39.07 | 35.06 | 35.06 | 39.72 | 32.02 | 39.00 |
| | (D-2) | | | | | | | | |
| | (D-3) | | | | | | | | |
| (E) | (E-1) | 0.20 | 0.20 | 0.20 | 0.20 | 0.20 | 0.20 | 0.20 | 0.20 |
| | (E-2) | | | | | | | | |
| (F) | (F-1) | 2.00 | 2.00 | 2.00 | 2.00 | 2.00 | 2.00 | 2.00 | 2.00 |
| | (F-2) | | | | | | | | |
| (g1) | (G-1) | | | | 5.00 | 5.00 | | | |
| | (G-2) | | | | | | | | |
| (g2) | (G-3) | 0.20 | | | | | | | |
| | (G-4) | | | 0.20 | 0.20 | 0.20 | 0.20 | 0.20 | 0.20 |
| (g3) | (G-5) | 10.00 | 10.00 | 0.00 | 5.00 | 5.00 | 10.00 | 10.00 | 10.00 |

(continued)

| Table 1 (Continued) | | | Example 17 | Example 18 | Example 19 | Example 20 | Example 21 | Example 22 | Example 23 | Com. Ex. 1 |
|---|---|---|---|---|---|---|---|---|---|---|
| | Total | | 100 | 100 | 100 | 100 | 100 | 100 | 100 | 100 |
| Equivalent num-ber calculation | [(A)+(B)+(C)]/(D) | | 1.000 | 1.000 | 1.000 | 1.000 | 1.000 | 0.840 | 1.160 | 1.000 |
| | (B)/(D) | | 0.200 | 0.200 | 0.200 | 0.200 | 0.200 | 0.126 | 0.230 | 0.000 |
| | (C)/(D) | | 0.200 | 0.200 | 0.200 | 0.200 | 0.200 | 0.126 | 0.230 | 0.000 |
| | [(B)+(C)]/(D) | | 0.400 | 0.400 | 0.400 | 0.400 | 0.400 | 0.252 | 0.460 | 0.000 |
| | (A)/(D) | | 0.600 | 0.600 | 0.600 | 0.600 | 0.600 | 0.588 | 0.700 | 1.000 |
| Evaluation results | Peel strength (UV) | Measured value (N) | 3.3 | 3.7 | 5.5 | 3.4 | 4.3 | 2.2 | 3.2 | 1.1 |
| | | Evaluation | ◎ | ◎ | ◎ | ◎ | ◎ | ◎ | ◎ | × |
| | Share strength (UV) | Measured value (N) | 21 | 23 | 18 | 20 | 19 | 24 | 31 | 70 |
| | | Evaluation | ◎ | ◎ | ○ | ◎ | ○ | ◎ | ◎ | ◎ |
| | Share strength (heat) | Measured value (N) | 95 | 96 | 51 | 69 | 107 | 83 | 107 | 80 |
| | | Evaluation | ◎ | ◎ | ◎ | ◎ | ◎ | ◎ | ◎ | ◎ |

[Table 1-4]

| Table 1 (Continued) | | | Com. Ex. 2 | Com. Ex. 3 | Com. Ex. 4 | Com. Ex. 5 | Com. Ex. 6 | Com. Ex. 7 | Com. Ex. 8 | Com. Ex. 9 | Com. Ex. 10 |
|---|---|---|---|---|---|---|---|---|---|---|---|
| (A) | | (A-1) | 46.13 | 12.18 | 12.75 | 11.66 | 25.54 | 22.01 | 26.92 | 20.80 | 20.63 |
| | | (A-2) | | | | | | | | | |
| | | (A-3) | | | | | | | | | |
| | | (A-4) | | | | | | | | | |
| (B) | | (B-1) | 1.32 | 19.45 | 40.72 | | 0.58 | 30.12 | 23.94 | 4.75 | |
| | | (B-2) | | | | | | | | | |
| | | (B-3) | | | | | | | | | |
| | | (B-4) | | | | | | | | | |
| | | (B-5) | | | | | | | | | |
| (B') | | (B-1') | | | | | | | | | 28.05 |
| (C) | | (C-1) | 1.58 | 23.38 | | 44.75 | 27.31 | 6.03 | 0.74 | 34.22 | 11.31 |
| | | (C-2) | | | | | | | | | |
| | | (C-3) | | | | | | | | | |
| (D) | | (D-1) | 38.57 | 32.59 | 34.12 | 31.19 | 34.17 | 29.44 | 36.01 | 27.83 | 27.60 |
| | | (D-2) | | | | | | | | | |
| | | (D-3) | | | | | | | | | |
| (E) | | (E-1) | 0.20 | 0.20 | 0.20 | 0.20 | 0.20 | 0.20 | 0.20 | 0.20 | 0.20 |
| | | (E-2) | | | | | | | | | |
| (F) | | (F-1) | 2.00 | 2.00 | 2.00 | 2.00 | 2.00 | 2.00 | 2.00 | 2.00 | 2.00 |
| | | (F-2) | | | | | | | | | |
| (g1) | | (G-1) | | | | | | | | | |
| | | (G-2) | | | | | | | | | |
| (g2) | | (G-3) | | | | | | | | | |
| | | (G-4) | 0.20 | 0.20 | 0.20 | 0.20 | 0.20 | 0.20 | 0.20 | 0.20 | 0.20 |
| (g3) | | (G-5) | 10.00 | 10.00 | 10.00 | 10.00 | 10.00 | 10.00 | 10.00 | 10.00 | 10.00 |
| Total | | | 100 | 100 | 100 | 100 | 100 | 100 | 100 | 100 | 100 |
| Equivalent num-ber calculation | | [(A)+(B)+(C)]/(D) | 1.000 | 1.000 | 1.000 | 1.000 | 1.000 | 1.300 | 1.000 | 1.300 | 0.800 |
| | | (B)/(D) | 0.020 | 0.350 | 0.700 | 0.000 | 0.010 | 0.600 | 0.390 | 0.100 | 0.000 |
| | | (C)/(D) | 0.020 | 0.350 | 0.000 | 0.700 | 0.390 | 0.100 | 0.010 | 0.600 | 0.200 |
| | | [(B)+(C)]/(D) | 0.040 | 0.700 | 0.700 | 0.700 | 0.400 | 0.700 | 0.400 | 0.700 | 0.200 |
| | | (A)/(D) | 0.960 | 0.300 | 0.300 | 0.300 | 0.600 | 0.600 | 0.600 | 0.600 | 0.600 |

(continued)

| Table 1 (Continued) | | | | | | | | | | | |
|---|---|---|---|---|---|---|---|---|---|---|---|
| | | | Com. Ex. 2 | Com. Ex. 3 | Com. Ex. 4 | Com. Ex. 5 | Com. Ex. 6 | Com. Ex. 7 | Com. Ex. 8 | Com. Ex. 9 | Com. Ex. 10 |
| Evaluation results | Peel strength (UV) | Measured value (N) | 1.5 | - | - | - | 2.6 | 9.4 | 6.4 | 2.1 | 0.1 |
| | | Evaluation | × | | | | ◎ | ◎ | ◎ | ◎ | × |
| | Share strength (UV) | Measured value (N) | 65 | 0 | 0 | 0 | 14 | 30 | 29 | 14 | 8 |
| | | Evaluation | ◎ | × | × | × | × | ◎ | ◎ | × | × |
| | Share strength (heat) | Measured value (N) | 60 | - | - | - | 156 | 22 | 28 | 173 | 147 |
| | | Evaluation | ◎ | | | | ◎ | × | × | ◎ | ◎ |

(Consideration of Results)

The composition without containing (B) a monofunctional (meth)acrylate compound and (C) an epoxy resin showed insufficient peel strength after UV curing (Comparative Example 1).

When [total number of (meth)acryloyl groups for the (B) monofunctional (meth)acrylate compound + total number of epoxy groups for the (C) epoxy resin] / [total number of thiol groups for the (D) polyfunctional thiol compound] was less than 0.1, the peel strength after UV curing was insufficient (Comparative Example 2). On the other hand, when [total number of (meth)acryloyl groups for the (B) monofunctional (meth)acrylate compound + total number of epoxy groups for the (C) epoxy resin] / [total number of thiol groups for the (D) polyfunctional thiol compound] exceeded 0.5, the shear strength after UV curing was insufficient (Comparative Examples 3 to 5).

When [total number of (meth)acryloyl groups for the (B) monofunctional (meth)acrylate compound] / [total number of thiol groups for the (D) polyfunctional thiol compound] was less than 0.05, the shear strength after UV curing was insufficient (Comparative Example 6). On the other hand, when [total number of (meth)acryloyl groups for the (B) monofunctional (meth)acrylate compound] / [total number of thiol groups for the (D) polyfunctional thiol compound] exceeded 0.45, the shear strength after heat curing was insufficient (Comparative Example 7).

When [total number of epoxy groups for the (C) epoxy resin] / [total number of thiol groups for the (D) polyfunctional thiol compound] was less than 0.05, the shear strength after heat curing was insufficient (Comparative Example 8). On the other hand, when [total number of epoxy groups for the (C) epoxy resin] / [total number of thiol groups for the (D) polyfunctional thiol compound] exceeded 0.45, the shear strength after UV curing was insufficient (Comparative Example 9).

In the composition containing a monofunctional (meth)acrylate compound with a molecular weight exceeding 400 instead of the (B) monofunctional (meth)acrylate compound, the shear strength after heat curing was sufficient, but the peel strength and shear strength after UV curing were insufficient (Comparative Example 10).

Industrial applicability

The curable resin composition of the present invention exhibits sufficiently high adhesive strength even when subjected only to either UV or thermal curing treatment. Even if stress is applied to the intermediate assembly before heat curing, in which each component has been temporarily fixed by UV curing the curable resin composition of the present invention, no peeling and/or misalignment of parts occurs. The curable resin composition of the present invention also provides high adhesion reliability of the final product, even when applied to positions where UV irradiation cannot be applied to the entirety. Therefore, the curable resin composition of the present invention is very useful for bonding parts of sensor modules, etc.

**Claims**

1.　A curable resin composition comprising the following components (A) to (F):

(A) a polyfunctional (meth)acrylate compound,

(B) a monofunctional (meth)acrylate compound with a molecular weight of 400 or less,
(C) an epoxy resin,
(D) a polyfunctional thiol compound,
(E) a photo-radical initiator, and
(F) a thermal curing accelerator,

wherein [total number of (meth)acryloyl groups for the (B) monofunctional (meth)acrylate compound + total number of epoxy groups for the (C) epoxy resin] / [total number of thiol groups for the (D) polyfunctional thiol compound] is 0.1 to 0.5, [total number of (meth)acryloyl groups for the (B) monofunctional (meth)acrylate compound] / [total number of thiol groups for the (D) polyfunctional thiol compound] is 0.05 to 0.45, and [total number of epoxy groups for the (C) epoxy resin] / [total number of thiol groups for the (D) polyfunctional thiol compound] is 0.05 to 0.45 and wherein the total numbers of (B), (C) and (D) are determined according to the methods mentioned in the specification.

2. The curable resin composition according to claim 1, wherein [total number of (meth)acryloyl groups for the (B) monofunctional (meth)acrylate compound + total number of epoxy groups for the (C) epoxy resin] / [total number of thiol groups for the (D) polyfunctional thiol compound] is 0.3 to 0.5 and wherein the total numbers of (B), (C) and (D) are determined according to the methods mentioned in the specification.

3. The curable resin composition according to claim 1 or 2, wherein the (D) polyfunctional thiol compound has three or more thiol groups.

4. The curable resin composition according to any one of claims 1 to 3, wherein the (D) polyfunctional thiol compound contains a trifunctional thiol compound and/or a tetrafunctional thiol compound.

5. The curable resin composition according to any one of claims 1 to 4, wherein the (A) polyfunctional (meth)acrylate compound contains a bifunctional (meth)acrylate compound.

6. An adhesive comprising the curable resin composition according to any one of claims 1 to 5.

7. A cured product obtainable by curing the curable resin composition according to any one of claims 1 to 5 or the adhesive according to claim 6.

8. A semiconductor device comprising the cured product according to claim 7.

9. A sensor module comprising the cured product according to claim 7.

**Patentansprüche**

1. Härtbare Harzzusammensetzung, umfassend die folgenden Komponenten (A) bis (F):

(A) eine polyfunktionelle (Meth)acrylatverbindung,
(B) eine monofunktionelle (Meth)acrylatverbindung mit einem Molekulargewicht von 400 oder weniger,
(C) ein Epoxidharz,
(D) eine polyfunktionelle Thiolverbindung,
(E) einen Photo-Radikalinitiator, und
(F) einen thermischen Härtungsbeschleuniger,

wobei [Gesamtzahl der (Meth)acryloylgruppen für die (B) monofunktionelle (Meth)acrylatverbindung + Gesamtzahl der Epoxidgruppen für das (C) Epoxidharz] / [Gesamtzahl der Thiolgruppen für die (D) polyfunktionelle Thiolverbindung] 0,1 bis 0,5 beträgt, [Gesamtzahl der (Meth)acryloylgruppen für die (B) monofunktionelle (Meth)acrylatverbindung] / [Gesamtzahl der Thiolgruppen für die (D) polyfunktionelle Thiolverbindung] 0,05 bis 0,45 beträgt, and [Gesamtzahl der Epoxidgruppen für das (C) Epoxidharz] / [Gesamtzahl der Thiolgruppen für die (D) polyfunktionelle Thiolverbindung] 0,05 bis 0,45 beträgt und wobei die Gesamtzahl von (B), (C) und (D) gemäß den in der Spezifikation genannten Methoden bestimmt werden.

2. Härtbare Harzzusammensetzung gemäß Anspruch 1, wobei [Gesamtzahl der (Meth)acryloylgruppen für die (B) monofunktionelle (Meth)acrylatverbindung + Gesamtzahl der Epoxidgruppen für das (C) Epoxidharz] / [Gesamtzahl der Thiolgruppen für die (D) polyfunktionelle Thiolverbindung] 0,3 bis 0,5 beträgt und wobei die Gesamtzahl von (B), (C) und (D) gemäß den in der Spezifikation genannten Methoden bestimmt werden.

3. Härtbare Harzzusammensetzung gemäß Anspruch 1 oder 2, wobei die (D) polyfunktionelle Thiolverbindung drei oder mehr Thiolgruppen aufweist.

4. Härtbare Harzzusammensetzung gemäß einem der Ansprüche 1 bis 3, wobei die (D) polyfunktionelle Thiolverbindung eine trifunktionelle Thiolverbindung und/oder eine tetrafunktionelle Thiolverbindung enthält.

5. Härtbare Harzzusammensetzung gemäß einem der Ansprüche 1 bis 4, wobei die (A) polyfunktionelle (Meth)acrylatverbindung eine bifunktionelle (Meth)acrylatverbindung enthält.

6. Klebstoff, umfassend die härtbare Harzzusammensetzung gemäß einem der Ansprüche 1 bis 5.

7. Gehärtetes Produkt, erhältlich durch Härten der härtbaren Harzzusammensetzung gemäß einem der Ansprüche 1 bis 5 oder des Klebstoffs gemäß Anspruch 6.

8. Halbleitervorrichtung, umfassend das gehärtete Produkt gemäß Anspruch 7.

9. Sensormodul, umfassend das gehärtete Produkt gemäß Anspruch 7.

**Revendications**

1. Composition de résine durcissable comprenant les constituants (A) à (F) suivants :

   (A) un composé de (méth)acrylate polyfonctionnel,
   (B) un composé de (méth)acrylate monofonctionnel avec un poids moléculaire de 400 ou moins,
   (C) une résine époxy,
   (D) un composé de thiol polyfonctionnel,
   (E) un initiateur photo-radicalaire, et
   (F) un accélérateur de durcissement thermique,

   dans laquelle [le nombre total de groupes (méth)acryloyle pour le composé de (méth)acrylate monofonctionnel de (B) + le nombre total de groupes époxy pour la résine époxy de (C)]/[le nombre total de groupes thiol pour le composé de thiol polyfonctionnel de (D)] est de 0,1 à 0,5, [le nombre total de groupes (méth)acryloyle pour le composé de (méth)acrylate monofonctionnel de (B)]/[le nombre total de groupes thiol pour le composé de thiol polyfonctionnel de (D)] est de 0,05 à 0,45, et [le nombre total de groupes époxy pour la résine époxy de (C)]/[le nombre total de groupes thiol pour le composé de thiol polyfonctionnel de (D)] est de 0,05 à 0,4 et dans laquelle les nombres totaux de (B), (C) et (D) sont déterminés selon les procédés mentionnés dans le mémoire descriptif.

2. Composition de résine durcissable selon la revendication 1, dans laquelle [le nombre total de groupes (méth)acryloyle pour le composé de (méth)acrylate monofunctionnel de (B) + le nombre total de groupes époxy pour la résine époxy de (C)]/[le nombre total de groupes thiol pour le composé de thiol polyfonctionnel de (D)] est de 0,3 à 0,5 et dans laquelle les nombres totaux de (B), (C) et (D) sont déterminés selon les procédés mentionnés dans le mémoire descriptif.

3. Composition de résine durcissable selon la revendication 1 ou 2, dans laquelle le composé de thiol polyfonctionnel de (D) présente trois groupes thiol ou plus.

4. Composition de résine durcissable selon l'une quelconque des revendications 1 à 3, dans laquelle le composé de thiol polyfonctionnel de (D) contient un composé de thiol trifonctionnel et/ou un composé de thiol tétrafonctionnel.

5. Composition de résine durcissable selon l'une quelconque des revendications 1 à 4, dans laquelle le composé de (méth)acrylate polyfonctionnel de (A) contient un composé de (méth)acrylate bifonctionnel.

6. Adhésif comprenant la composition de résine durcissable selon l'une quelconque des revendications 1 à 5.

7. Produit durci pouvant être obtenu par durcissement de la composition de résine durcissable selon l'une quelconque des revendications 1 à 5 ou de l'adhésif selon la revendication 6.

8. Dispositif à semi-conducteurs comprenant le produit durci selon la revendication 7.

9. Module de détection comprenant le produit durci selon la revendication 7.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2014077024 A
- WO 2018181421 A
- JP 2021075698 A
- US 2017158922 A1
- JP 2012153794 A